# EUROPÄISCHE PATENTSCHRIFT

(11) **EP 2 219 064 B1**
(45) Veröffentlichungstag und Bekanntmachung des Hinweises auf die Patenterteilung: **16.09.2020**
(21) Anmeldenummer: 10001240.0
(22) Anmeldetag: 06.02.2010
(51) Int. Cl.: G02B 27/09, H01S 3/00, G02B 19/00, H01S 5/40, H01S 5/00

(54) **Laseroptik sowie Diodenlaser**
Laser lens and diode laser
Optique laser ainsi que laser à diodes

(30) Priorität: 13.02.2009 DE 102009008918; 22.06.2009 DE 102009030120; 30.06.2009 DE 102009031046
(43) Veröffentlichungstag der Anmeldung: 18.08.2010
(73) Patentinhaber: Laserline Gesellschaft für Entwicklung und Vertrieb von Diodenlasern mbH, 56218 Mülheim-Kärlich (DE)
(72) Erfinder: Krause, Volker, 56298 Lonnig (DE); Ullmann, Christoph, 53604 Bad Honnef (DE); Rehmann, Georg, 56070 Koblenz (DE); Kösters, Arnd, 55425 Waldalgesheim (DE)
(74) Vertreter: Glück Kritzenberger Patentanwälte PartGmbB

(56) Entgegenhaltungen:
- EP-A2- 0 863 588
- EP-A2- 1 081 819
- DE-A1- 10 012 480
- DE-A1- 19 705 574
- DE-A1- 19 743 322
- DE-A1- 19 918 444
- DE-C1- 19 841 285

## Beschreibung

Die Erfindung bezieht sich auf einen Diodenlaser entsprechend dem Oberbegriff des Patentanspruches 1.

Im Gegensatz zu konventionellen Laserstrahlquellen, die einen Strahldurchmesser von einigen mm bei einer geringen Strahldivergenz im Bereich von wenigen mrad aufweisen, zeichnet sich die Strahlung eines Halbleiter- oder Diodenlasers (nachstehend "Diodenlaser") durch einen in der Fast-Axis stark divergenten Strahl mit einer Divergenz > 1000 mrad aus. Hervorgerufen wird dies von der auf < 1 µm Höhe begrenzten Austrittsschicht, an der ähnlich der Beugung an einer spaltförmigen Öffnung, ein großer Divergenzwinkel erzeugt wird. Da die Ausdehnung der Austrittsöffnung in der Ebene senkrecht und parallel zur aktiven Halbleiterschicht unterschiedlich ist, kommen verschiedene Strahldivergenzen in der Ebene senkrecht und parallel zur aktiven Schicht zustande.

Um eine Leistung von 20 - 40 W für einen Diodenlaser zu erreichen, werden zahlreiche Laser-Emitter auf einem sog. Laserbarren zu einem Laserbauelement zusammengefasst. Üblicherweise werden hierbei 10 - 50 einzelne Emittergruppen in einer Reihe in der Ebene parallel zur aktiven Schicht angeordnet. Der resultierende Strahl eines solchen Barrens hat in der Ebene parallel zur aktiven Schicht einen Öffnungswinkel von ca. 10° und einen Strahldurchmesser von ca. 10 mm. Die resultierende Strahlqualität in dieser Ebene ist um ein Vielfaches geringer als die sich ergebende Strahlqualität in der zuvor beschriebenen Ebene senkrecht zur aktiven Schicht. Auch bei einer möglichen zukünftigen Verringerung der Divergenzwinkel von Laser-Chips bleibt das stark unterschiedliche Verhältnis der Strahlqualität senkrecht und parallel zur aktiven Schicht bestehen.

Der Strahl verfügt aufgrund der zuvor beschriebenen Strahlcharakteristik über einen großen Unterschied der Strahlqualität in beiden Richtungen senkrecht und parallel zur aktiven Schicht. Der Begriff der Strahlqualität wird dabei beschrieben durch den M² Parameter. M² ist definiert durch den Faktor, mit dem die Strahldivergenz des Diodenlaserstrahles über der Strahldivergenz eines beugungsbegrenzten Strahles gleichen Durchmessers liegt. In dem oben gezeigten Fall verfügt man in der Ebene parallel zur aktiven Schicht über einen Strahldurchmesser, der um den Faktor 10.000 über dem Strahldurchmesser in der senkrechten Ebene liegt. Bei der Strahldivergenz verhält es sich anders, d.h. in der Ebene parallel zur aktiven Schicht bzw. in der Slow-Axis wird eine fast 10-fach kleinere Strahldivergenz erreicht. Der M² Parameter in der Ebene parallel zur aktiven Schicht liegt also um mehrere Größenordnungen über dem M² Wert in der Ebene senkrecht zur aktiven Schicht.

Ein mögliches Ziel einer Strahlformung ist es, einen Strahl mit nahezu gleichen M² Werten in beiden Ebenen, d.h. senkrecht und parallel zur aktiven Schicht zu erreichen. Bekannt sind derzeit folgende Verfahren zur Umformung der Strahlgeometrie durch die eine Annäherung der Strahlqualitäten in den beiden Hauptebenen des Strahles erreicht wird.

Mittels eines Faserbündels lassen sich linienförmige Strahlquerschnitte durch Umordnen der Fasern zu einem kreisrunden Bündel zusammenfassen. Solche Verfahren sind z.B. in den US-Patentschriften 5 127 068, 4 763 975, 4 818 062, 5 268 978 sowie 5 258 989 beschrieben.

Daneben besteht die Technik des Strahldrehens, bei dem die Strahlung einzelner Emitter um 90° gedreht wird, um so eine Umordnung vorzunehmen bei der eine Anordnung der Strahlen in Richtung der Achse der besseren Strahlqualität erfolgt. Zu diesem Verfahren sind folgende Anordnungen bekannt: US 5 168 401, EP 0 484 276, DE 4 438 368. Allen Verfahren ist gemein, dass die Strahlung eines Diodenlasers nach dessen Kollimation in der Fast-Axis-Richtung, um 90° gedreht wird um eine Slow-Axis-Kollimation mit einer gemeinsamen Zylinderoptik vorzunehmen. In Abwandlung der genannten Verfahren ist auch eine durchgehende Linienquelle denkbar (z.B. die eines in Fast-Axis-Richtung kollimierten Diodenlasers hoher Belegungsdichte), deren Strahlprofil (Linie) aufgeteilt wird und in umgeordneter Form hinter dem optischen Element vorliegt.

Daneben besteht die Möglichkeit, ohne eine Drehung des Strahles eine Umordnung der Strahlung einzelner Emitter vorzunehmen, wobei durch z.B. durch den parallelen Versatz (Verschieben) mittels paralleler Spiegel eine Umordnung der Strahlung erreicht wird (WO 95/15510). Eine Anordnung, die sich ebenfalls der Technik des Umordnens bedient, ist in DE 195 00 53 und DE 19 5 44 488 beschrieben. Hierbei wird die Strahlung eines Diodenlaserbarrens in verschiedene Ebenen abgelenkt und dort einzeln kollimiert.

Die Nachteile des Standes der Technik lassen sich u.a. dahingehend zusammenfassen, dass bei fasergekoppelten Diodenlasern meist ein Strahl mit sehr unterschiedlichen Strahlqualitäten in beiden Achsrichtungen in die Faser eingekoppelt wird. Bei einer kreisrunden Faser bedeutet dies, dass in einer Achsrichtung die mögliche numerische Apertur oder der Faserdurchmesser nicht genutzt wird. Dies führt zu erheblichen Verlusten bei der Leistungsdichte, sodass in der Praxis eine Beschränkung auf ca. 10⁴ W/cm² erfolgt.

Bei den genannten bekannten Verfahren müssen weiterhin teilweise erhebliche Weglängenunterschiede kompensiert werden. Dies geschieht meist durch Korrekturprismen, die Fehler nur begrenzt ausgleichen können. Vielfachreflexionen stellen weiterhin erhöhte Anforderungen an Justagegenauigkeit, Fertigungstoleranzen sowie Bauteilstabilität (WO 95/15510). Reflektierende Optiken (z.B. aus Kupfer) verfügen über hohe Absorptionswerte.

Bekannt ist weiterhin eine Laseroptik der gattungsbildenden Art zum Umformen wenigstens eines Laserstrahlenbündels, unter Verwendung von wenigstens zwei im Strahlengang aufeinander folgend angeordneten optischen Umformelementen, von denen wenigstens ein Umformelement als sogenannter Plattenfächer ausgebildet ist (EP 1 081 819 A2, DE 100 12 480 A1, DE 197 05 574 A1, DE 198 41 285 C1, EP 0 863 588 A2, DE 199 18 444 A1).

Aus der DE 197 43 322 A1 ist insbesondere ein Laserstrahlformgebungssystem bekannt, bei dem ein horizontal langgestreckter Laserstrahl in mehrere Strahlabschnitte unterteilt wird, die sich horizontaler Richtung erstrecken, wobei die Strahlabschnitte durch eine strahlablenkende Plattenanordnung unterschiedlich zueinander vertikal abgelenkt werden. Die Plattenanordnung umfasst hierbei mehrere transparente Platten, die einen Plattenstapel bilden, wobei jeweils ein Strahlabschnitt durch eine der Platten auf einem zu der Hauptoberfläche der Platten parallelen Weg hindurchgeleitet wird, der zwischen der Plattenoberflächen geführt wird. Aufgrund der bestehenden Strahldivergenz und gewählten Plattendicke der Plattenanordnung wird der jeweilige Laserstrahl zwischen den Plattenoberflächen einer Platte in mehrfach reflektiert.

Aufgabe der Erfindung ist es, einen Diodenlaser der gattungsbildenden Art im Sinne einer Verbesserung der Fokussierung der Laserstrahlung weiter zu bilden. Zur Lösung dieser Aufgabe ist ein Diodenlaser entsprechend dem Patentanspruch 1 ausgebildet.

Unter "Diodenlaser" sind im Sinne der Erfindung insbesondere auch sogenannte Single-Mode-Laser und/oder Breitstreifen-Laser und/oder Breitstreifen-Gruppen-Laser und/oder Trapez-Laser zu verstehen. "Emitter" sind im Sinne der Erfindung insbesondere auch die Emitter der vorgenannten Laser.

Unter "Plattenfächer" ist im Sinne der Erfindung ein vom Laserlicht durchstrahltes optisches Element zu verstehen, welches sich aus mehreren Platten oder plattenförmigen Elementen aus einem lichtleitenden Material, vorzugsweise Glas, zusammensetzt, die stapelartig aneinander anschließen und fächerartig gegen einander verdreht sind. Jede Platte oder jedes plattenförmige Element bilden an einander gegenüberliegenden Seiten eine Plattenschmalseite für den Lichteintritt oder -austritt und sind unter Berücksichtigung der Anordnung der Emitter und der Divergenz, die die Laserstrahlen in der Slow-Axis aufweisen, so positioniert und ausgebildet, dass an den Oberflächenseiten innerhalb der Platte eine Reflexion des jeweiligen Laserstrahl nicht erfolgt.

Unter "Oberflächenseiten" sind im Sinne der Erfindung jeweils die großen Plattenseiten zu verstehen.

Unter "Plattendicke" ist im Sinne der Erfindung der Abstand zu verstehen, den die beiden Oberflächenseiten der jeweiligen Platte von einander aufweisen.

Der Plattenfächer kann durch Zusammensetzen aus einzelnen Platten oder plattenförmigen Elementen oder aber auch einstückig, beispielsweise als Formteil mit entsprechenden optischen Trenn- oder Zwischenschichten hergestellt sein.

Mit den im Lichtweg hintereinander angeordneten Umformelementen erfolgt bei der Laseroptik eine Auffächerung des Laserstrahles in unterschiedlichen Ebenen angeordnete Einzelstrahlen und ein anschließendes Übereinanderschieben dieser Einzelstrahlen.

Bei einer Ausführungsform der Erfindung sind wenigstens zwei, vorzugsweise aber mehr als zwei Emitterebenen mit jeweils wenigstens einer eine Vielzahl von Emittern bzw. Dioden aufweisenden Emittergruppe vorgesehen. Die Laserstrahlung jeder Emittergruppe wird durch ein erstes Umformelement so aufgefächert, dass für jede Emittergruppe eine eigene Teilstrahlgruppe mit Teilstrahlen erhalten wird, die in zwei senkrecht zur Strahlungsrichtung verlaufenden Achsen gegeneinander versetzt sind. Die Teilstrahlgruppen schließen in einer ersten Achse aneinander an, und zwar vorzugsweise ohne Abstand oder Zwischenraum zwischen diesen Teilstrahlgruppen. Durch ein zweites Umformelement werden dann sämtliche Teilstrahlen sämtlicher Gruppen durch Verschieben in der ersten Achse, die auch die Achse ist, in der die Emitter der Emittergruppen aufeinander folgen oder dieser Achse entspricht, übereinandergeschoben, so dass diese Teilstrahlen einen gemeinsamen umgeformten Laserstrahl bilden, der beispielsweise einen balkenförmigen Querschnitt mit einer Breite besitzt, die derjenigen Länge entspricht, die die Teilstrahlen in der ersten Achse aufweisen, und der in einer Fokussieroptik in einen Fokus fokussiert werden kann. Als Umformelemente werden vorzugsweise wieder Plattenfächer verwendet.

Erfindungsgemäß ist die Laseroptik so ausgebildet, dass die Platten des Plattenfächers eine Plattendicke aufweisen, die zumindest gleich, vorzugsweise aber größer ist als die Divergenz, die der wenigstens eine, von dem jeweiligen Emitter bzw. von der jeweiligen Emittergruppe ausgesendete und die zugehörige Platte durchstrahlende Laserstrahl an der zweiten Plattenschmalseite in Slow-Axis-Richtung aufweist.

Weitere Vorteile der Erfindung sind darin zu sehen, dass jede Platte nur einem Emitter oder nur einem Laserstrahl zugeordnet ist,
und/oder
dass der Emitterabstand, den zwei einander benachbarte Emitter oder zwei einander benachbarte Emittergruppen in Richtung der Slow-Axis voneinander aufweisen, gleich der Dicke der Platten oder einem Vielfachen der Dicke der Platten ist,
und/oder
dass im Strahlengang zwischen den Emittern und dem Plattenfächer wenigstens ein Fast-Axis-Kollimator vorgesehen ist,
und/oder
dass der Fast-Axis-Kollimator für sämtliche Emitter gemeinsam vorgesehen ist, und/oder
dass mehrere Fast-Axis-Kollimatoren, vorzugsweise individuell einstellbare Fast-Axis-Kollimatoren vorgesehen sind, und zwar jeweils ein Fast-Axis Kollimator für jeden Emitter oder eine Emittergruppe,
und/oder
dass der Plattenfächer ein Auffächern des wenigstens einen Laserstrahlbündels in mehrere Teilstrahlen bewirkt, die in der Fast-Axis sowie auch in der Slow-Axis gegeneinander versetzt sind,
und/oder
dass im Strahlengang auf den Plattenfächer folgend wenigstens ein weiteres Umformelement zum Zusammenführen der durch den Plattenfächer aufgefächerten Teilstrahlen vorgesehen ist,
und/oder
dass das weiter Umformelement ein weiterer Plattenfächer ist, dessen Platten mit ihren Oberflächenseiten senkrecht zur Fast-Axis der Laserstrahlen orientiert sind, und/oder
dass die Plattenschmalseiten des wenigstens einen Plattenfächers fächerartig derart gegeneinander verdreht sind, dass die erste Plattenschmalseite jeder Platte in einer Ebene liegt, die mit der Ebene der ersten Plattenschmalseite jeder benachbarten Platte einen Winkel (α) einschließt, dass die ersten Plattenschmalseiten in ihrer Gesamtheit eine erste Plattenfächerseite und die zweiten Plattenschmalseiten in ihrer Gesamtheit eine zweite Plattenfächerseite jeweils für den Eintritt oder Austritt des den Plattenfächer durchstrahlenden wenigstens einen Laserstrahls bilden, und dass die Ebenen der Plattenschmalseiten sowie die Fächerachse senkrecht zu den Oberflächenseiten der Platten orientiert sind,
und/oder
dass die Plattenschmalseiten an jeder Platte parallel oder im Wesentlichen parallel zueinander angeordnet sind,
und/oder
dass die Platten des Plattenfächers jeweils von wenigstens zwei aufeinander liegenden Einzelplatten gebildet sind,
und/oder
dass in wenigstens zwei Emitterebenen, die parallel zueinander angeordnet und in einer Achse senkrecht zu den Emitterebenen um einen Abstand voneinander beabstandet sind, jeweils wenigstens eine Emittergruppe vorgesehen ist dass die Laserstrahlen jeder Emittergruppe durch ein erstes Umformelement in eine eigene Teilstrahlgruppe von aufgefächerten Teilstrahlen umgeformt wird, dass die Teilstrahlgruppen in der zweiten Achse gegeneinander versetzt sind, und dass durch das zweite Umformelement die Teilstrahlen sämtlicher Teilstrahlgruppen zu dem aus den zweiten Umformelement austretenden umgeformten Laserstrahl umgeformt werden,
und/oder
dass die durch das erste Umformelement gebildeten Teilstrahlgruppen derart in der zweiten Achse versetzt sind, und dass der Abstand zwischen jeweils gleichartigen Teilstrahlen benachbarter Gruppen dem Abstand der Emitterebenen der Laserdiodenanordnung entspricht,
und/oder
dass die Emittergruppen jeweils von einem mehrere Emitter aufweisenden Laserbarren gebildet ist,
und/oder
dass in jeder Emitterebene eine Emittergruppe vorgesehen ist,
und/oder
dass das erste Umformelement von wenigstens einem ersten Plattenfächer gebildet ist,
und/oder
dass der erste Plattenfächer für sämtliche Emitterebenen gemeinsam vorgesehen ist, und/oder
dass das zweite Umformelement von wenigstens einem zweiten Plattenfächer gebildet ist,
und/oder
dass der zweite Plattenfächer für sämtliche Teilstrahlgruppen der durch das erste Umformelement umgeformten Laserstrahlen gemeinsam vorgesehen ist, und/oder
dass der zweite Plattenfächer aus mehreren aneinander anschließenden Einzelplattenfächern besteht und beispielsweise für jede Teilstrahlgruppe einen Einzelplattenfächer aufweist,
und/oder
dass der zweite Plattenfächer eine Vielzahl von Platten aus einem lichtdurchlässigen Material aufweist,
und/oder
dass die Anzahl dieser Platten gleich der Anzahl der durch das erste Umformelement gebildeten Teilstrahlen (107') ist,
und/oder
dass der zweite Plattenfächer eine Vielzahl von Platten aus einem lichtdurchlässigen Material aufweist,
und/oder
dass die Anzahl dieser Platten gleich der Anzahl der Emitterebenen multipliziert mit der Anzahl der Platten ist, die der wenigstens eine erste Plattenfächer jeweils aufweist,
und/oder
dass Kollimatoren (106, 116) im Strahlengang der Laserlichtstrahlung angeordnet sind,
und/oder
dass eine Fokussieroptik zum Fokussieren des umgeformten Laserstrahls in einem Fokus vorgesehen ist,
und/oder
dass wenigstens ein Slow-Axis-Kollimator im Strahlengang nach dem zweiten Umformelement vorgesehen ist,
und/oder das im Strahlengang der Laserstrahlung eine den Laserstrahl in der Slow-Axis aufweitende optische Anordnung vorgesehen ist, und zwar nach dem zweiten Umformelement und vorzugsweise vor einer als Fast-Axis-Kollimator wirkenden optischen Anordnung, wobei die vorgenannten Merkmale jeweils einzeln oder in beliebiger Kombination vorgesehen sein können.

Weiterbildungen, Vorteile und Anwendungsmöglichkeiten der Erfindung ergeben sich auch aus der nachfolgenden Beschreibung von Ausführungsbeispielen und aus den Figuren. Dabei sind alle beschriebenen und/oder bildlich dargestellten Merkmale für sich oder in beliebiger Kombination grundsätzlich Gegenstand der Erfindung, unabhängig von ihrer Zusammenfassung in den Ansprüchen oder deren Rückbeziehung. Auch wird der Inhalt der Ansprüche zu einem Bestandteil der Beschreibung gemacht.

Die Erfindung wird im folgenden anhand der Figuren an Ausführungsbeispielen näher erläutert. Es zeigen:
Fig. 1 in vereinfachter Darstellung einen Diodenlaser, bestehend aus einer eine Vielzahl von Laserelementen oder Laserchips aufweisenden Laserdiodenanordnung und einer im Strahlengang dieser Laserdiodenanordnung angeordneten von zwei Plattenfächern gebildeten optischen Anordnung zur Formung des Laserstrahls, wobei die Zeichenebene dieser Figur senkrecht zur aktiven Schicht der Diodenelemente liegt;
Fig. 2 den Diodenlaser der Fig. 1, wobei die Zeichenebene dieser Figur parallel zu der aktiven Schicht der Diodenelement liegt;
Fig. 3 und 4 in vereinfachter Darstellung die Ausbildung des Laserstrahls vor dem Umformen, beim Umformen und nach dem Umformen;
Fig. 5 und 6 einen der optischen Plattenfächer in Seitenansicht sowie in Draufsicht;
Fig. 7 und 8 einen Diodenlaser ähnlich dem Diodenlaser der Fig. 1 und 2, jedoch mit einer im Strahlengang nach den beiden Plattenfächern angeordneten Fokussieroptik bestehend aus einer Zylinderlinse und einer sphärischen Sammellinse, wobei die Zeichenebene der Fig. 7 senkrecht zur aktiven Schicht und die Zeichenebene der Fig. 8 parallel zur aktiven Schicht der Diodenelemente liegt;
Fig. 9 und 10 in ähnlicher Darstellung wie Fig. 1 und 2 eine weitere mögliche Ausführungsform, bei der im Strahlengang lediglich ein Plattenfächer und daran anschließend ein gestufter Spiegel (Treppenspiegel) vorgesehen ist;
Fig. 11 - 18 in Prinzipdarstellungen verschiedene Dioden-Laser-Laserbarren;
Fig. 19 in vereinfachter Darstellung einen Diodenlaser, bestehend aus einer mehrere Laser-Chips oder -barren aufweisenden Laserdiodenanordnung und einer Laseroptik zur Umformung der Laserstrahlen, wobei die Zeichenebene dieser Figur senkrecht zur aktiven Schicht der Laserbarren liegt;
Fig. 20 den Diodenlaser der Figur 19, allerdings in einer Darstellung, in der die Zeichenebene dieser Figur parallel zur aktiven Schicht der Diodenelemente liegt, wobei die Divergenz der Laserstrahlen in der Slow-Achse aus Gründen der übersichtlicheren Darstellung und besseren Erläuterung wegen übertrieben dargestellt ist;
Fig. 21 in den Positionen a, b und c jeweils in vereinfachter Darstellung die Ausbildung des Laserstrahls an verschiedenen Positionen innerhalb der Laseroptik der Figuren 19 und 20;
Fig. 22 und 23 in Darstellungen ähnlich den Figuren 19 und 20 eine weitere mögliche Ausführungsform der Erfindung;
Fig. 24 in den Position a, b und c jeweils in vereinfachter Darstellung die Ausbildung des Laserstrahls an verschiedenen Positionen innerhalb der Laseroptik der Figuren 22 und 23,
Fig. 25 - 32 Diodenlaser gemäß weiterer Ausführungsform der Erfindung.

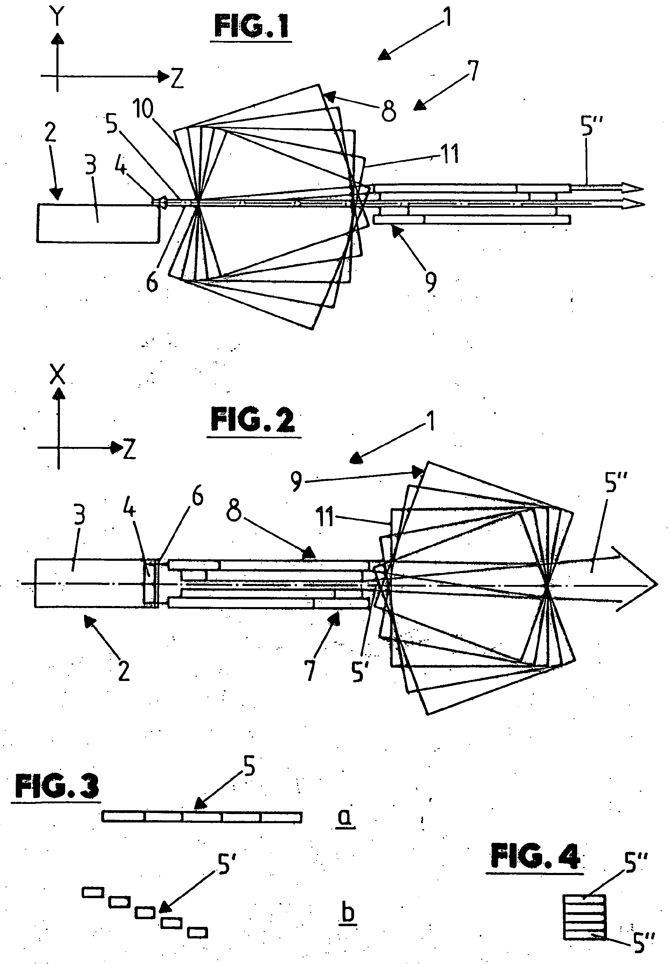

In den Figuren sind der besseren Übersichtlichkeit wegen jeweils mit X, Y und Z senkrecht zueinander verlaufende Raumachsen, nämlich die X-Achse, Y-Achse und Z-Achse bezeichnet. Die Zeichenebene z.B. der Figuren 1, 7, 9 und 19 liegt dementsprechend in der von der Y-Achse und der Z-Achse definierten Y-Z-Ebene, die Zeichenebene z.B. der Figur 2, 8, 10 und20 in der X-Z-Ebene und die Zeichenebene der Figur 3 in der X-Y-Ebene.

Der in den Figuren 1 und 2 dargestellte Diodenlaser 1 besteht im wesentlichen aus einer Laserdiodenanordnung 2, die an einem u.a. auch als Wärmesenke ausgebildeten Substrat 3 ein Laserbarren 4 mit einer Vielzahl von Laserlicht aussendenden Emittern 4.1 aufweist, die gleichsinnig orientiert sind und insbesondere auch mit ihren aktiven Schichten in einer gemeinsamen Ebene senkrecht zur Zeichenebene der Fig. 1 bzw. parallel zur Zeichenebene der Fig. 2 liegen, d.h. in einer X-Z-Ebene, die durch die in den Figuren angegebene X-Achse und Z-Achse definiert ist.

Im Strahlengang der von dem Laserbarren 4 ausgehenden Laserstrahlung in Form eines Strahlenbündels aus Einzelstrahlen 5 befindet sich ein Fast-Axis-Kollimator 6, der beispielsweise von einer mit ihrer Achse in der X-Achse liegenden Zylinderlinse gebildet ist und eine Kollimation der Laserstrahlung bzw. der Einzelstrahlen 5 in ihrer sog. Fast-Axis, d.h. in der Y-Achse und damit in der Y-Z-Ebene senkrecht zur aktiven Schicht wirkt, in der die Strahlung der Emitter 4.1 des Laserbarrens 4 die größere Divergenz aufweist. Nach dem Fast-Axis-Kollimator 6 steht die Laserstrahlung im wesentlichen als schmalbandiges Strahlenbündel aus den Einzelstrahlen 5 zur Verfügung, wie dies in der Fig. 3 angedeutet ist.

Auf den Fast-Axis-Kollimator 6 folgend ist im Strahlengang der Laserstrahlung eine optische Einrichtung 7 zur weiteren Formung des Laserstrahlbündels vorgesehen, und zwar beispielsweise in der Weise, dass das Strahlenbündel (Fig. 3 - Position a) zunächst in Einzelstrahlen 5' in verschiedenen Ebenen parallel zur X-Z-Ebene zertrennt bzw. aufgefächert wird, die von Ebene zu Ebene auch in der X-Achse gegen einander versetzt sind (Fig. 3 - Position b), und diese Einzelstrahlen 5' dann diagonal übereinander geschoben werden, wie dies in der Fig. 4 mit 5" schematisch gezeigt ist.

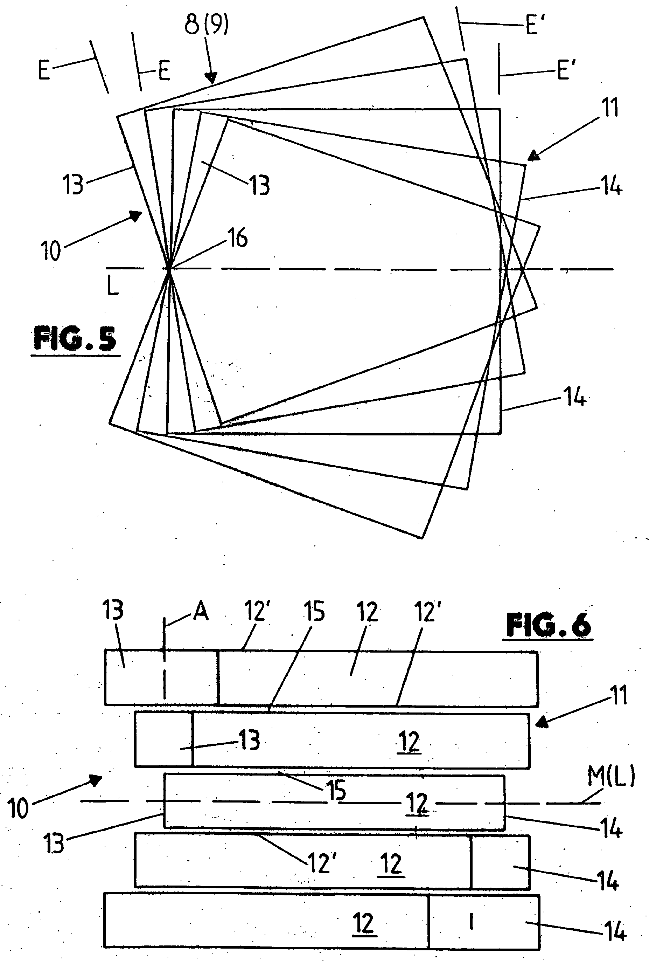

Die optische Einrichtung 7 besteht hierfür aus zwei Plattenfächern 8 und 9, die bei der dargestellten Ausführungsform grundsätzlich identisch ausgebildet sind, allerdings um 90° um die Z-Achse gedreht beidseitig von einer die Z-Achse senkrecht schneidenden gedachten Mittelebene so angeordnet sind, dass beide Plattenfächer jeweils mit einer gleichartig ausgebildeten Fächerseite 10 von dieser Mittelebene wegweisen und mit einer gleichartig ausgebildeten Fächerseite 11 dieser Mittelebene zugewandt sind. Der Aufbau beispielsweise des Plattenfächers 8 ist in den Fig. 5 und 6 im Detail dargestellt. Der Plattenfächer 9 ist in der gleichen Weise ausgebildet, sodass die nachfolgende Beschreibung auch für diesen Plattenfächer gilt.

Der Plattenfächer 8 besteht aus mehreren dünnen Platten12, die aus einem Licht leitenden Material, beispielsweise Glas hergestellt sind und bei der dargestellten Ausführungsform jeweils einen quadratischen Zuschnitt aufweisen. Jede Platte 12 besitzt zwei plane Plattenschmalseiten 13 und 14, die die Seiten für den Eintritt und den Austritt der Laserstrahlen bilden und hierfür optisch hochwertig ausgebildet, d.h. poliert und mit einer Anti-Reflexionsschicht versehen sind. Die beiden Seiten 13 und 14 liegen sich an jeder Platte 12 gegenüber und sind bei der dargestellten Ausführungsform parallel zueinander angeordnet. Bei der Darstellung der Fig. 5 und 6 ist davon ausgegangen, dass der Plattenfächer 8 von insgesamt fünf Platten 12 gebildet ist. Theoretisch sind auch weniger oder mehr als fünf Platten 12 möglich.

Die Platten 12 schließen mit ihren Oberflächenseiten 12', an denen sie ebenfalls poliert sind, stapelartig aneinander an, wobei zwischen jeweils zwei benachbarten Platten 12 ein Spalt 15 vorgesehen ist, der von einem Medium, welches einen im Vergleich zum Material der Platten 12 kleineren optischen Brechungsindex aufweist, ausgefüllt ist. Der Spalt 15 ist beispielsweise ein Luftspalt, bevorzugt ist der jeweilige Spalt 15 aber mit einem die Platten 12 verbindenden Material, beispielsweise mit einem optischen Kitt ausgefüllt.

Die Platten 12 sind fächerartig gegeneinander versetzt. Bei der dargestellten Ausführungsform sind die Platten 12 hierfür um eine gemeinsame Fächerachse A gegen einander gedreht, wobei außerdem jeweils ein vorgegebener Bereich 16 der Plattenschmalseite 13, nämlich bei der dargestellten Ausführungsform die Mitte jeder Plattenschmalseite 13 jeder Platte 12 zusammen mit dem entsprechenden Bereichen 16 der übrigen Platten auf der gemeinsamen Achse A liegt, die senkrecht zu den Ebenen der Oberflächenseiten 12' der Platten 12 liegt und damit auch senkrecht zu einer parallel zu diesen Oberflächenseiten angeordneten, gedachten Mittelebene M des Plattenfächers 8. Um die Achse A bzw. um ihre Bereiche 16 sind die einzelnen Platten 12 derart fächerartig gegeneinander verdreht oder aufgefächert, dass die Ebenen E der Plattenschmalseiten 13 zweier benachbarter Platten sich in der Achse A schneiden und einen Winkel α miteinander einschließen, der in der Fig. 5 übertrieben groß dargestellt ist und beispielsweise in der Größenordnung von 1 - 5° liegt. Die mittlere Platte 12 liegt mit der Ebene E ihrer Plattenschmalseite 13 senkrecht zu einer Längserstreckung L oder optischen Achse des Plattenfächers 8. Die Gesamtheit der Plattenschmalseiten 13 aller Platten 12 bildet die Plattenfächerseite 10. Entsprechend der Anordnung der Plattenschmalseiten 13 sind auch die Plattenschmalseiten 14, die in ihrer Gesamtheit die Plattenfächerseite 11 bilden, so relativ zueinander angeordnet, dass die Ebenen E' zweier benachbarter Plattenseiten 14 wiederum den Winkel α miteinander einschließen. Die Ebenen E und E' der Plattenschmalseiten 13 und 14 liegen senkrecht zu den Ebenen der Oberflächenseiten 12'.

Der Plattenfächer 8 ist weiterhin so ausgebildet, da die an die mittlere Platte 12 anschließenden Platten jeweils symmetrisch gedreht bzw. aufgefächert sind, d.h. für die für die Fig. 5 gewählte Darstellung die auf der einen Plattenschmalseite der mittleren Platte 12 vorgesehenen Platten 12 mit ihren Plattenschmalseiten 13 im Gegenuhrzeigersinn und die auf der anderen Plattenschmalseite der mittleren Platte 12 anschließenden Platten mit ihren Plattenschmalseiten 13 gegenüber der mittleren Platte im Uhrzeigersinn gedreht sind.

Die Breite des jeweiligen Spaltes 15 ist möglichst gering, aber ausreichend groß gewählt (z.B. einige 1/100 mm), um sicherzustellen, dass auch bei einer leichten Verwölbungen einer oder mehrerer Platten 12 ein direkter Berührungskontakt zwischen zwei benachbarten Platten 12 nicht entsteht und somit Strahlungsverluste vermieden werden, die an derartigen Berührungsstellen auftreten und zur Reduzierung der Effizienz des Systems führen könnten.

Der Plattenfächer 8 ist bei dem Diodenlaser 1 derart angeordnet, dass er mit seiner Längsachse L in der Z-Achse liegt und die Mittelachse M in der Y-Z-Ebene, wobei die Plattenfächerseite 10 der Laserdiodenanordnung 2 zugewandt ist, das Strahlenbündel aus den Laserstrahlen 5 also an der Plattenfächerseite 10 in diesen Plattenfächer eintritt. Der Plattenfächer 9 ist mit seiner Längsachse L, die senkrecht zur Plattenschmalseite 13 der mittleren Platte 12 liegt und die Achse A senkrecht schneidet ebenfalls in der Z-Achse angeordnet, und zwar achsgleich mit der Achse L des Plattenfächers 8, wobei die Plattenfächerseite 11 des Plattenfächers 9 der Plattenfächerseite 11 des Plattenfächers 8 zugewandt ist. Die Mittelebene M des Plattenfächers 9 liegt in der X-Z-Ebene, sodass der Plattenfächer 9 gegenüber dem Plattenfächer 8 um 90° um die Z-Achse gedreht wird.

Die Besonderheit der Laseroptik 7 besteht zunächst darin, dass an dem Plattenfächer 8, der auf den Fast-Axis-Kollimator 6 im Strahlengang folgt, jedem Emitter 4.1 des Laserbarrens 4 eine eigene Platte 12 zugeordnet ist, und zwar derart, dass der im Fast-Axis-Kollimator 6 kollimierte Laserstrahl 5 jedes Emitters 4.1 näherungsweise mittig und senkrecht auf die diesem Emitter zugewandte plane Plattenschmalseite 13 auftrifft, der Achsabstand, den die Emitter 4.1 in der Slow-Axis der Laserstrahlen 5, d.h. bei der Darstellung der Figuren 1 und 2 in der X-Achse voneinander besitzen, gleich demjenigen Abstand ist, den die parallel zu den Oberflächenseite 12' orientierten Mittelebenen zweier benachbarter Platten 12 voneinander besitzen.

Weiterhin ist die Plattendicke (Abstand der Oberflächenseiten 12') jeder Platte 12 wenigstens gleich, vorzugsweise aber größer als die Divergenz, die der Laserstrahl 5 des zugehörigen Emitter 4.1 in der Slow-Axis aufweist, d.h. bei der für die Figuren 1 und 2 gewählten Darstellung in der X-Achse, und zwar am Austritt der jeweiligen Platte, d.h. an der Plattenstirnseite 14. Hierdurch ist gewährleistet, dass es nicht zu Reflexionen (Totalreflexionen) des jeweiligen Laserstrahls 5 innerhalb der zugehörigen Platte 12 im Bereich der Oberflächenseiten 12' kommt und jeder aus dem Plattenfächer 8 austretende Einzelstrahl 5.1 punktförmig oder im Wesentlichen punktförmig ist.

In analoger Weise ist dann beispielsweise der im Strahlengang anschließende Plattenfächer 9 so ausgebildet, dass jedem aus einer Platte 12 des Plattenfächers 8 austretenden Laserstrahl 5' eine Platte 12 des Plattenfächers 9 zugeordnet ist, auf jeden Fall aber die Plattendicke der Platten 12 des Plattenfächers 9 wenigstens gleich oder größer ist als die Divergenz, die die durch den Fast-Axis-Kollimator 6 kollimierten Einzelstrahlen 5.2 am Austritt aus dem Plattenfächer 9 in dieser Fast-Axis, d.h. bei der für die Figuren 1 und 2 gewählten Darstellung in der Y-Achse aufweisen.

Grundsätzlich besteht auch die Möglichkeit, zumindest den Plattenfächer 8 abweichend von der vorstehend beschriebenen idealen Ausführung so auszubilden, dass jeweils für eine Emittergruppe mit einer kleineren Anzahl von Emittern, beispielsweise für zwei oder maximal drei Emitter 4.1 eine Platte 12 gemeinsam vorgesehen ist, und zwar beispielsweise dann, wenn der Abstand, den die Emitter 4.1 in der Slow-Axis, d.h. in der X-Achse von ein ander aufweisen, kleiner oder gleich der Divergenz der Laserstrahlen 5 in der Slow-Axis ist. Auch in diesem Fall sind die Anordnung so getroffen und die Plattendicke so gewählt, dass keiner der Laserstrahlen 5 der Emitter 4.1 eine Reflexion innerhalb der zugehörigen Platte 12 im Bereich der Oberflächenseiten 12.1 erfährt, die Plattendicke jeder Platte 12 also gleich der Summe des Abstandes zwischen den Emittern 4.1 der jeweiligen Emittergruppe und der Divergenz ist, die diese Emitter bzw. deren Laserstrahlen 5 in der Slow-Axis aufweisen.

Die Länge, die der jeweilige Emitterbarren in Richtung der Slow-Axis, d.h. in Richtung der X-Achse aufweist, beträgt beispielsweise 10 mm. Der Abstand der einzelnen Emitter 4.1 an dem Laserbarren 4 ist dann beispielsweise größer 1 mm und kleiner 3 mm. Die Anzahl der Platten 12 des Plattenfächers 8 liegt beispielsweise im Bereich zwischen drei und zehn Platten.

Der durch den Fast-Axis-Kollimator 6 kollimierte Laserstrahl 5 trifft auf die Plattenfächerseite 13 auf, und zwar im Bereich der Achse A bzw. der Längsachse L.

Durch die unterschiedliche Neigung der Plattenschmalseiten 13 und der Plattenseiten 14 wird das eintretende Laserstrahlbündel in die verschiedenen Einzelstrahlen 5' aufgeteilt, die parallel oder im wesentlichen parallel zur Z-Achse an den Plattenseiten 14 aus dem Plattenfächer 8 austreten, wobei die Einzelstrahlen 5' bedingt durch die Brechung an den Plattenschmalseiten 13 und 14 in unterschiedlichen Ebenen parallel zur X-Z-Ebene angeordnet sind.

Die einzelnen Einzelstrahlen 5' treten dann jeweils an einer Plattenseite 14 in den Plattenfächer 9 ein. Durch die Brechung an den Plattenschmalseiten 13 und 14 treten sämtliche Einzelstrahlen 5' an den Plattenschmalseiten 13 der Platten 12 des Plattenfächers 9 aus, und zwar im Bereich der dort parallel zur Y-Achse liegenden Achse A, sodass die Einzelstrahlen 5' diagonal verschoben übereinander angeordnet sind, wie dies in der Fig. 4 dargestellt ist.

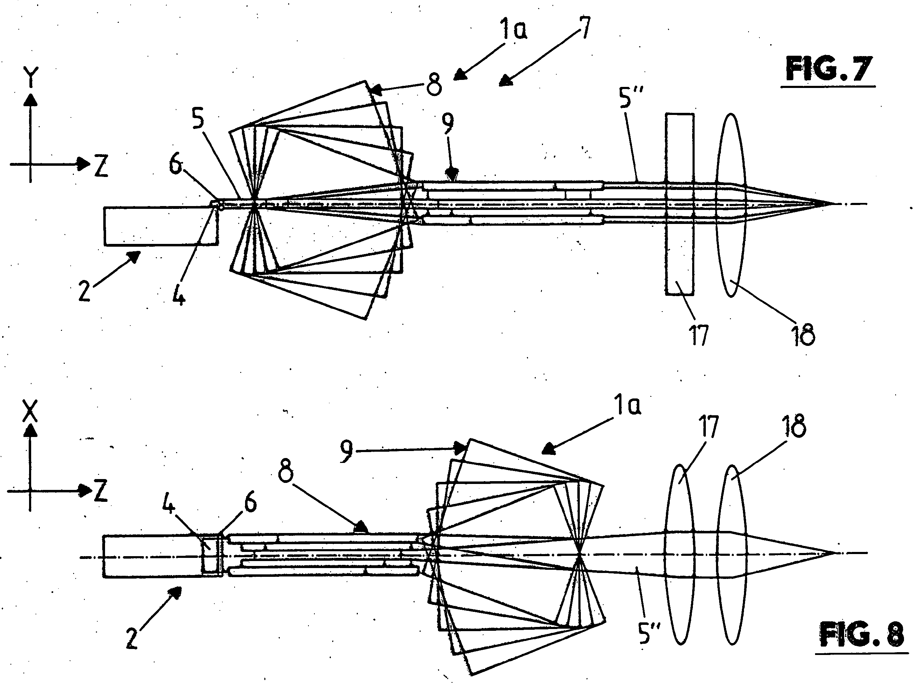

Die Fig. 7 und 8 zeigen einen Diodenlaser 1a, der sich von dem Diodenlaser 1 lediglich dadurch unterscheidet, dass im Strahlengang nach der optischen Anordnung 7 ein Slow-Axis-Kollimator 17 in Form einer Zylinderlinse vorgesehen ist, die mit ihrer Achse parallel zur Y-Achse angeordnet ist. Durch diesen Kollimator 17 wird die Divergenz, die die Einzelstrahlen 5' in der Slow-Axis, d.h. in der X-Achse aufweisen, korrigiert, sodass anschließend mehrere, in Richtung der Y-Achse übereinander angeordnete kollimierte Einzelstrahlen 5" vorliegen, die mittels einer Fokussieroptik, d.h. mittels der sphärischen Sammellinse 18 fokussiert werden.

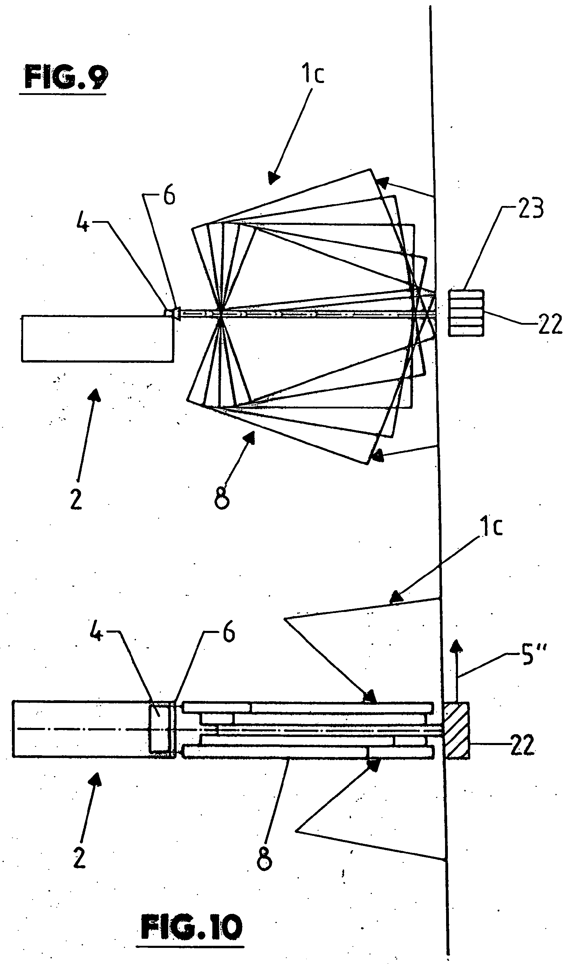

Die Fig. 9 und 10 zeigen als weitere Ausführungsform einen Diodenlaser 1c, der sich von dem Diodenlaser 1 der Fig. 1 und 2 nur dadurch unterscheidet, dass anstelle des im Strahlengang zweiten Plattenfächers 9 zum diagonalen Zusammenschieben des Strahlenbündels der Einzelstrahlen 5' (Position b der Fig. 3) in das Strahlenbündel der Einzelstrahlen 5" (Fg. 4) ein sog. Treppenspiegel 22 vorgesehen ist. Dieser besitzt eine Vielzahl von Spiegelflächen 23, die derart treppenartig in der gegeneinander versetzt sind, dass durch Reflexion an den Spiegelflächen das Umformen des Strahlenbündels der Einzelstrahlen 5' in das Strahlenbündel der Einzelstrahlen 5" erfolgt.

Der Plattenfächer 8 ist auch bei der in den Figuren 9 und 10 dargestellten Ausführungsform wiederum in gleicher Weise ausgebildet, wie dies vorstehend für den Plattenfächer 8 der Figuren 1 und 2 beschrieben wurde. Sämtlichen Ausführungen der Erfindung ist also gemeinsam, dass zumindest der erste, im Strahlengang angeordnete Plattenfächer 8 in Bezug auf seine Platten 12 derart angeordnet und ausgebildet ist, dass die an der Plattenschmalseite 13 eintretenden Einzel- oder Laserstrahlen 5 des Laserstrahlbündels ohne Reflexion, insbesondere auch ohne Totalreflexion innerhalb der jeweiligen Platte an der Schmalseite 14 dieser Platte als Einzelstrahl 5.1 austreten.

Vorstehend wurden die Diodenlaser 1 bzw. deren Laseranordnungen 2 allgemein bestehend aus einem als Wärmesenke ausgebildeten Substrat 3 und aus einem Laserbarren 4 mit einer Vielzahl von Laserlicht aussendenden Emittern 4.1 beschrieben. Speziell der jeweilige Laserbarren 4 kann in unterschiedlichster Weise ausgeführt sein.

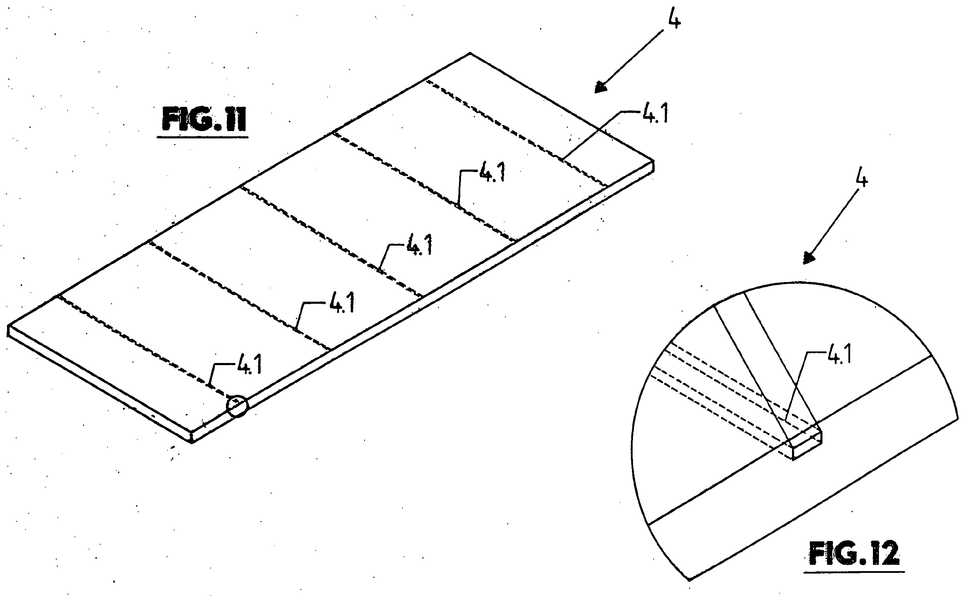

So zeigen die Figuren 11 und 12 in vereinfachter perspektivischer Darstellung (Figur 11) sowie in einer vergrößerten Teildarstellung (Figur 12) einen Laserbarren 4, der als Single-Mode-Laserbarren ausgeführt ist, und zwar mit fünf Emittern 4.1 in Form von Single-Mode-Emittern. Die typische Breite der Emitter 4.1 in der Slow-Axis (X-Achse) ihrer Laserstrahlen beträgt etwa 2 - 5 *µ*m und der Abstand zwischen zwei in der Slow-Axis
(X-Achse) aufeinander folgenden Emitter 4.1 beträgt etwa 1 - 3 mm. Der Laserbarren 4 besitzt beispielsweise in der X-Achse eine Länge von etwa 10 mm und in der Z-Achse eine Breite von etwa 2 bis 4 mm. Mit jedem Emitter 4.1 ist eine Leistung bis 1 W erreichbar.

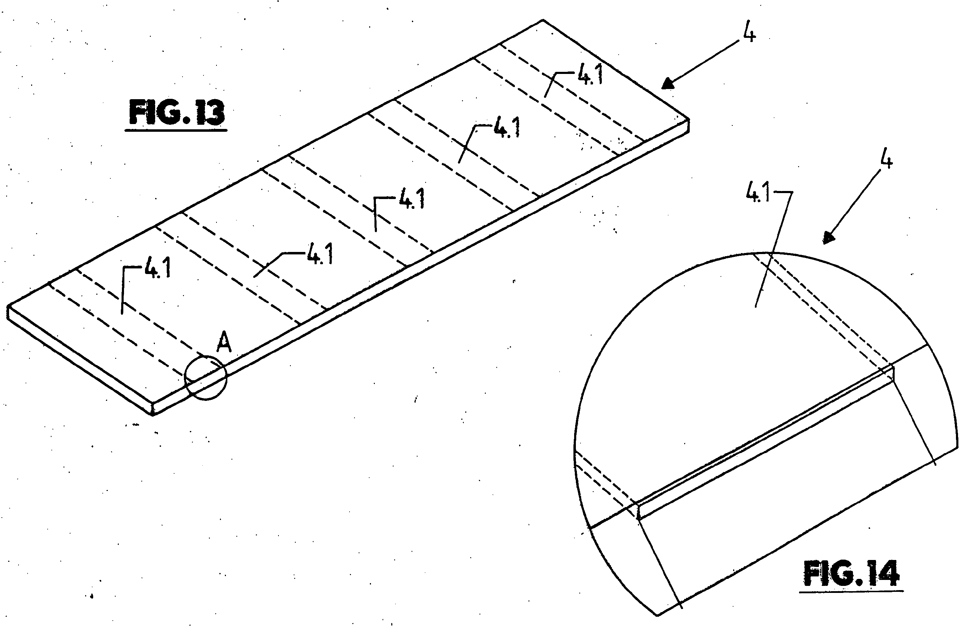

Die Figuren 13 und 14 zeigen einen Laserbarren 4, der als Breitstreifen-Laser-Barren ausgeführt ist, und zwar bei der dargestellten Ausführungsform mit insgesamt fünf Emittern 4.1 in Form von Breitsteifen-Emittern. Die Breite, die die Emitter 4.1 in Richtung ihrer Slow-Axis (X-Achse) aufweisen liegt im Bereich zwischen etwa 50 und 500 *µ*m. Der Abstand zwischen den einzelnen Emittern 4.1 in der Slow-Axis (X-Achse) ist beispielsweise größer als die vorgenannte Breite der Emitter 4.1. Der Laserbarren 4 besitzt beispielsweise in der X-Achse eine Länge von etwa 10 mm und in der Z-Achse eine Breite von etwa 2 bis 4 mm. Mit jedem Emitter 4.1 ist eine Leistung bis 20 W erreichbar.

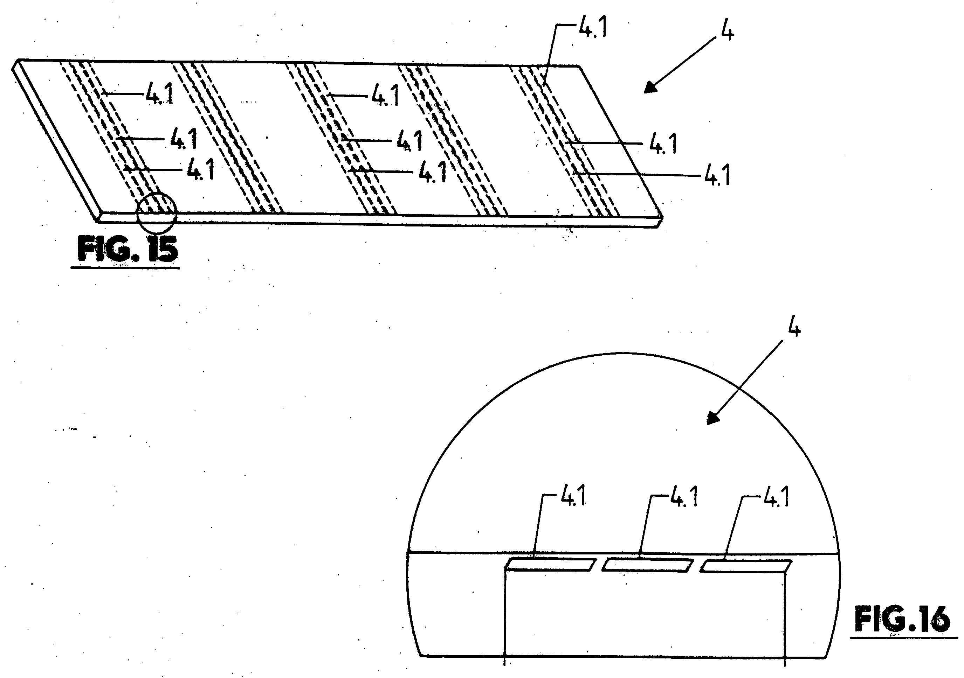

Die Figuren 15 und 16 zeigen einen Laserbarren 4 in Form eines Breitstreifen-Gruppen-Laserbarrens mit insgesamt fünf Gruppen von Emittern 4.1, die jeweils als Breitstreifenemitter ausgeführt sind. Bei der dargestellten Ausführungsform weist jede Emittergruppe insgesamt drei Emitter 4.1 auf. In der Praxis sind Ausführungen möglich, in denen die Anzahl der Emitter 4.1 in jeder Breitstreifen-Emittergruppe hiervon abweichen, beispielsweise jede Breitstreifen-Emittergruppe z.B. zwei bis fünf Emitter 4.1 aufweist. Unabhängig von der Anzahl der Emitter 4.1 beträgt die dann die Gesamtbreite, die jede Emittergruppe in der X-Achse aufweist etwa 200 bis 600 *µ*m. Der Laserbarren 4 besitzt beispielsweise in der X-Achse eine Länge von etwa 10 mm und in der Z-Achse eine Breite von etwa 2 bis 4 mm. Mit den einzelnen Breitstreifen-Emittergruppen sind jeweils Leistungen bis 30 W möglich.

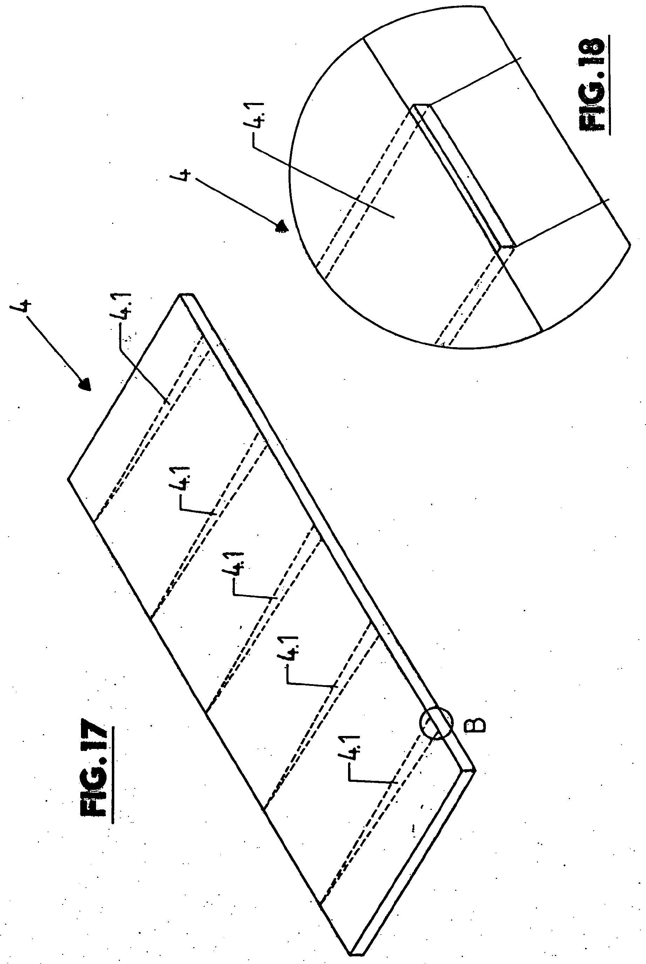

Die Figuren 17 und 18 zeigen einen Laserbarren 4, der als Trapez-Laser-Barren mit fünf Emittern 4.1 in Form von Trapez-Laser-Emittern ausgeführt ist. Die Emitter 4.1 besitzen an ihrer Laserlichtaustrittsöffnung an der Vorderseite des Laserbarrens 4 in Richtung der Slow-Axis (X-Achse) eine Breite im Bereich zwischen etwa 100 und 400 *µ*m, und zwar bei einem Achsabstand der einzelnen Emittern 4.1 beispielsweise in der Größenordnung zwischen 1 mm - 3 mm. Die einzelnen Emitter 4.1 sind so ausgeführt, dass sie im aktivierten Zustand innerhalb des Laserbarrens 4 eine zu der Vorderseite dieses Barrens hin leicht divergierende Strahlung ausbilden, und zwar mit einem Divergenzwinkel von etwa 2 bis 6° und ausgehend von einem Strahlpunkt, der gegenüber der Vorderseite des Laserbarrens 4 um etwa 2 bis 5 mm in der Z-Achse zur Laserbarrenrückseite versetzt ist und von dieser einen Abstand von etwa 400 bis 1000 *µ*m aufweist, wie dies in der Figur 17 mit den unterbrochenen Linien angedeutet ist. Mit den Emittern 4.1 lässt sich bei dieser Ausführung jeweils eine Leistung von bis zu 10 W erreichen. Speziell mit dem als Trapez-Laser-Barren ausgebildeten Laserbarren 4 lässt sich eine besonders hohe Brillanz für den Diodenlaser mit der vorbeschriebenen Laseroptik erreichen.

Die Höhe der Emitter 4.1 in der Fast-Axis (Y-Achse) beträgt bei den vorstehend beschriebenen Barren 4 beispielsweise 1 *µ*m.

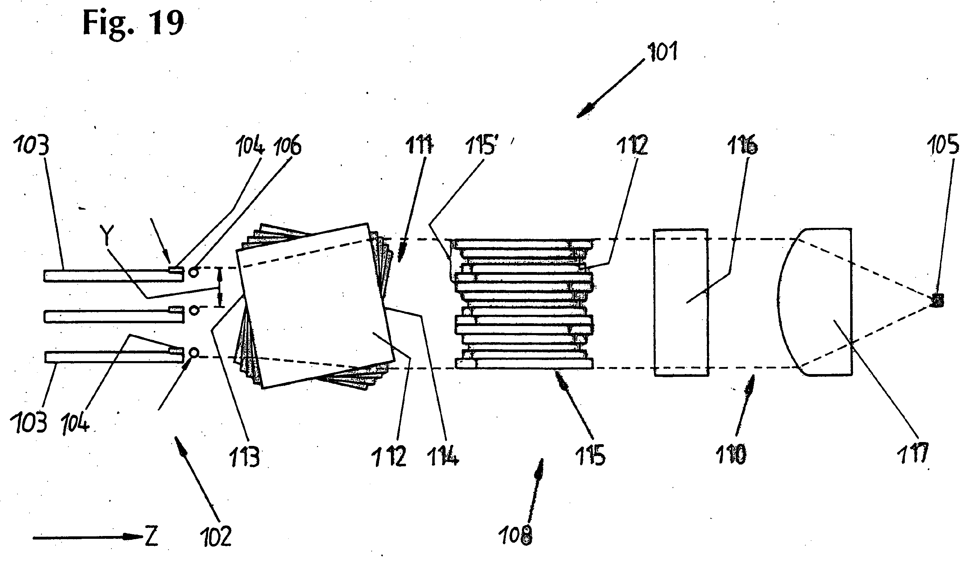

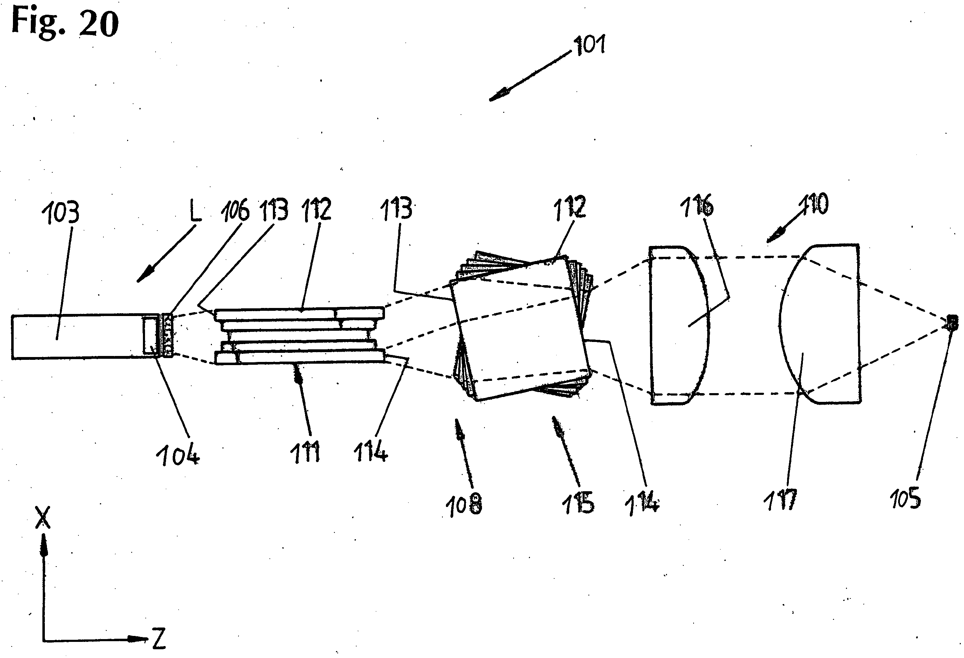

Der in den Figuren 19 - 21 dargestellte Diodenlaser 101 besteht im wesentlichen aus einer Diodenlaseranordnung 102, die mehrere jeweils an einem u.a. als Wärmesenke ausgebildeten Substrat 103 vorgesehene Laserbauelemente bzw. -barren 104 aufweist. Jeder Laserbarren 104 besitzt eine Vielzahl von Laserlicht aussendenden Diodenelementen oder Emittern, die gleichsinnig orientiert und in jedem Laserbarren 104 in Richtung der X-Achse gegeneinander versetzt sind sowie insbesondere auch mit ihren aktiven Schichten in einer gemeinsamen Ebene senkrecht zur Zeichenebene der Figur 19 bzw. parallel zur Zeichenebene der Figur 20 liegen, d.h. bei der für die Figuren gewählten Darstellung in der X-Z-Ebene.

Weiterhin sind die Laserbarren 104 parallel zueinander und in Richtung der Y-Achse um einen vorgegebenen Betrag y voneinander beabstandet. Dieser Abstand ergibt sich u.a. konstruktiv durch die Dicke, die die Substrate 103 in dieser Achsrichtung aufweisen.

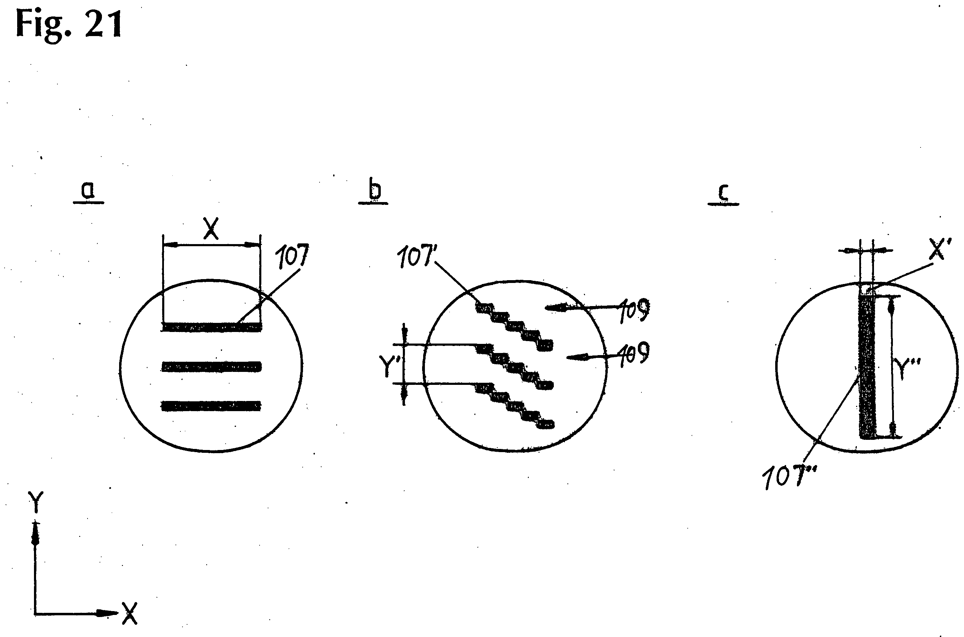

Der Diodenlaser 101 umfaßt weiterhin die nachstehend näher beschriebene Laseroptik 108, mit der die Laserstrahlung der einzelnen Laserbarren 104 in einem gemeinsamen Fokus 105 fokussiert wird. Diese Laseroptik 108 umfaßt u.a. Fast-Axis-Kollimatoren 106, von denen jeweils einer jedem Laserbarren 104 zugeordnet ist und die jeweils eine Kollimation des Laserstrahls 107 des zugehörigen Laserbarren 104 in der Fast-Axis, d.h. in der Y-Achse und damit in der Y-Z-Ebene senkrecht zur aktiven Schicht bewirken, in der der Laserstrahl der Emitter des betreffenden Laserbarrens 104 die größere Divergenz aufweist. Bei der dargestellten Ausführungsform sind die Fast-Axis-Kollimatoren 106 jeweils von einer Mikrolinse, nämlich von einer Zylinderlinse gebildet, die mit ihrer Achse in der X-Achse liegt. Nach dem Durchtritt durch den Fast-Axis-Kollimator 106 steht der Laserstrahl 107 jedes Laserbarrens im wesentlichen als schmalbandiger Strahl zur Verfügung, dessen größere Abmessung x in der X-Achse liegt, wie dies in der Figur 21 in der Position a angegeben ist.

Auf die Fast-Axis-Kollimatoren 106 in Richtung der optischen Achse (Z-Achse) folgend weist die Laseroptik 108 im Strahlengang der Laserstrahlen 107 eine optische Anordnung zum weiteren Formen der Laserstrahlen auf, und zwar in der Weise, dass in einem ersten Umformelement, welches für die Laserstrahlen 107 sämtlicher Laserbarren 104 gemeinsam vorgesehen ist, jeder Laserstrahl 107 zunächst in Teilstrahlen 107' zertrennt wird, die in verschiedenen Ebenen parallel zur X-Z-Ebene aufgefächert und von Ebene zu Ebene in der X-Achse gegeneinander versetzt sind, wie dies in der Position b der Figur 21 dargestellt ist. Diese Darstellung zeigt auch, dass die Teilstrahlen 107' jedes Laserbarrens 104 jeweils eine Teilstrahlgruppe 109 von aufgefächerten Teilstrahlen 107' bildet, wobei die Anzahl der Gruppen 109 gleich der Anzahl der Laserbarren 104 bzw. der Emitterebenen der Laserdiodenanordnung 102 ist, in denen die Laserbarren 104 angeordnet sind. Jede Gruppe 109 besitzt weiterhin in Richtung der Y-Achse eine Höhe y', die dem Abstand y entspricht. Weiterhin schließen die Gruppen 109 bei der dargestellten Ausführungsform unmittelbar aneinander an, d.h. der Abstand zwischen der Ebene des letzten Teilstrahls 107' einer Gruppe 109 und der Ebene des ersten Teilstrahls 107' der nächsten Gruppe 109 ist gleich oder im wesentlichen gleich dem Abstand, den die Ebenen der Teilstrahlen 107' innerhalb jeder Gruppe 109 voneinander aufweisen. Die Abmessung x', die die Teilstrahlen 107' in den Gruppen 109 in der X-Achse aufweisen, ist gleich oder etwa gleich der Abmessung x dividiert durch die Anzahl der Teilstrahlen 107' je Gruppe 109.

Bei der dargestellten Ausführungsform ist jeder Laserstrahl 107 in fünf Teilstrahlen 107' aufgefächert, so dass bei insgesamt drei Gruppen insgesamt fünfzehn Teilstrahlen 107' erhalten sind.

In einem nächsten Schritt wird in der Laseroptik 108 eine Umformung der Teilstrahlen 107' derart vorgenommen, dass diese Teilstrahlen 107' in ihrer X-Z-Ebene übereinandergeschoben werden, so dass die Teilstrahlen 107' deckungsgleich liegen und einen umgeformten balkenförmigen Laserstrahl 107" bilden, wie dies in der Position c der Figur 21 angedeutet ist. Dieser Laserstrahl 107" besitzt dann in Richtung der Y-Achse seine größere Abmessung y", die der Höhe y' multipliziert mit der Anzahl der Gruppen 109 entspricht. Die Breite des Laserstrahls 107" ist gleich der Abmessung x' der Teilstrahlen 107'. Der balkenförmige Laserstrahl 107" wird dann anschließend in einer Fokussieranordnung 110 im Fokus 105 fokussiert.

Das vorstehend beschriebene Prinzip der Strahl-Umformung hat u.a. den Vorteil, dass die Laserstrahlung einer Vielzahl von Laserbarren 104, die in Richtung der Y-Achse gegeneinander versetzt in der Laserdiodenanordnung 102 vorgesehen sind, in dem gemeinsamen Fokus 105 fokussiert werden kann, somit also bei hoher Strahlqualität eine hohe Leistungsdichte erzielbar ist, wobei der konstruktiv notwendige und nicht vermeidbare Abstand y zwischen den einzelnen Ebenen, in denen die Laserbarren 104 angeordnet sind, für das Umformen genutzt wird. Ein weiterer Vorteil besteht darin, dass die Laseroptik 108 und insbesondere auch deren Umformelemente sehr einfach und damit auch preiswert realisiert werden können.

Als erstes Umformelement enthält die Laseroptik 108 im Strahlengang auf die Fast-Axis-Kollimatoren 106 folgend einen ersten Plattenfächer 111, der aus einer Vielzahl von dünnen Platten 112 aus einem lichtleitendes Material, beispielsweise aus Glas hergestellt ist. Bei der dargestellten Ausführungsform weisen die Platten 112 einen quadratischen Zuschnitt auf. Jede Platte 112 besitzt zwei plane Plattenseiten 113 und 114, die optisch hochwertig ausgebildet, d.h. poliert und mit einer Anti-Reflexionsschicht versehen sind und von denen die Schmalseite 113 den Lichteintritt und die Schmalseite 114 den Lichtaustritt bilden. Die Platten 112 schließen mit ihren Oberflächenseiten, die ebenfalls poliert sind, stapelartig aneinander an. Zwischen benachbarten Platten 112 ist beispielsweise Luft oder ein Medium vorgesehen, welches die Platten verbindet und zugleich eine Totalreflexion des Laser-Lichtes innerhalb der Platten 112 an deren Oberflächenseiten sicherstellt. Die Platten 112, die mit ihren Oberflächenseiten jeweils in der Y-Z-Ebene angeordnet sind, sind um wenigstens eine Fächerachse fächerartig gegeneinander verdreht oder aufgefächert, und zwar derart, dass die Ebenen der Plattenschmalseiten 113 bzw. 114 zweier benachbarten Platten einen Winkel miteinander einschließen, der z.B. in der Größenordnung von 1 bis 5° liegt. Die einzelnen Platten 112 sind jeweils von Platte zu Platte in gleichem Richtungssinn um die Fächerachse zueinander verdreht. Die Dicke der Platten 112 beträgt beispielsweise 1 mm. Durch die Platten 112 erfolgt das Auffächern der Laserstrahlen 107 sämtlicher Laserbarren 104 in die Teilstrahlen 107' bzw. in die einzelnen Gruppen 109, wobei die Anzahl der Platten 112 die Anzahl der Teilstrahlen 107' in jeder Gruppe 109 bestimmt, d.h. bei der dargestellten Ausführungsform weist der Plattenfächer 111 insgesamt fünf Platten 112 auf. Die Ausbildung und Anordnung des Plattenfächers 112 sind weiterhin so getroffen, dass die parallel zu den Oberflächenseiten der Platten 112 liegende Mittelebene des Plattenfächers 111 mit der Y-Z-Mittelebene der Laserstrahlen 107 zusammenfällt und dass weiterhin die Ebene, in der die wenigstens eine Fächerachse liegt, eine X-Z-Ebene ist, und zwar die Mittel- oder Symmetrieebene sämtlicher von der Laserdiodenanordnung 102 ausgehender Laserstrahlen 107.

Zum Umformen der Teilstrahlen 107' in den Laserstrahl 107" ist im Strahlengang auf dem Plattenflächer 112 folgend ein weiterer Plattenfächer 115 vorgesehen. Dieser Plattenfächer 115 besteht aus mehreren Einzelplattenfächern 115', die in Richtung der Y-Achse aneinander anschließen, wobei die Anzahl der Einzelplattenfächer 115' gleich der Anzahl der Gruppen 109 und damit gleich der Anzahl der Ebenen ist, in denen in der Laserdiodenanordnung 102 Laserbarren 104 vorgesehen sind. Bei der dargestellten Ausführungsform weist somit der Plattenfächer 115 drei Einzelplattenfächer 115' auf. Jeder Einzelplattenfächer 115' besteht wiederum aus mehreren Platten 112, die stapelartig aneinander anschließen und fächerartig gegeneinander verdreht sind, und zwar um wenigstens eine Fächerachse, d.h. jeder Einzelplattenfächer 115' besitzt im wesentlichen die Ausbildung, wie sie vorstehend für den Plattenfächer 111 beschrieben wurde.

Die Platten 112 der Einzelplattenfächer 115 sind aber mit ihren Oberflächenseiten in der X-Z-Ebene angeordnet, d.h. in einer Ebene, die um 90° gegenüber der Ebene der Platten 112 des Plattenfächers 111 um die Z-Achse gedreht ist. Die Anzahl der Platten 112 in jedem Einzelplattenfächer 115' ist gleich der Anzahl der Teilstrahlen 107' in jeder Gruppe 109 und damit gleich der Anzahl der Platten 112 im Plattenfächer 111. Der Plattenfächer 115 kann also im Prinzip unter Verwendung der gleichen Platten 112 wie der Plattenfächer 111 hergestellt werden. Bei einer entsprechenden Ausbildung ist es weiterhin auch möglich, den Plattenfächer 115 durch Übereinanderstapeln mehrerer Plattenfächer 111 zu realisieren.

Die Anzahl der Platten 112 in dem Plattenfächer 115 ist somit gleich der Anzahl der Platten 112 im Plattenfächer 111 multipliziert mit der Anzahl der Ebenen, in denen in der Laserdiodenanordnung 102 Laserbarren 104 in der Y-Achse gegeneinander versetzt vorgesehen sind.

Während durch die fächerartige Anordnung der Platten 112 im Plattenfächer 111 das Auffächern der Laserstrahlen 107 in die Teilstrahlen 107' jeder Gruppe 109 erfolgt, werden durch den Plattenfächer 115 die Teilstrahlen 107' in der X-Achse übereinander geschoben und in den Strahl 107" umgeformt.

Die Fokussieranordnung 110 ist bei der dargestellten Ausführungsform von einer Zylinderlinse 116 gebildet, die auf dem Plattenfächer 115 folgt u.a. eine Kollimation des Strahles 107" in der Slow-Axis, d.h. in der X-Achse bewirkt, so dass im Strahlengang nach der Zylinderlinse 116 eine im wesentlichen parallele Strahlung vorliegt, die dann mit der Sammellinse 117 in dem Fokus 105 fokussiert wird.

Laufzeitunterschiede, insbesondere auch in den Teilstrahlen 107' können durch Verschieben der einzelnen Platten 112 des jeweiligen Plattenfächers relativ zueinander in der optischen Achse oder aber durch unterschiedliche Abmessungen der Platten 112 (Abstand zwischen den Stirnflächen 113 und 114) ausgeglichen werden.

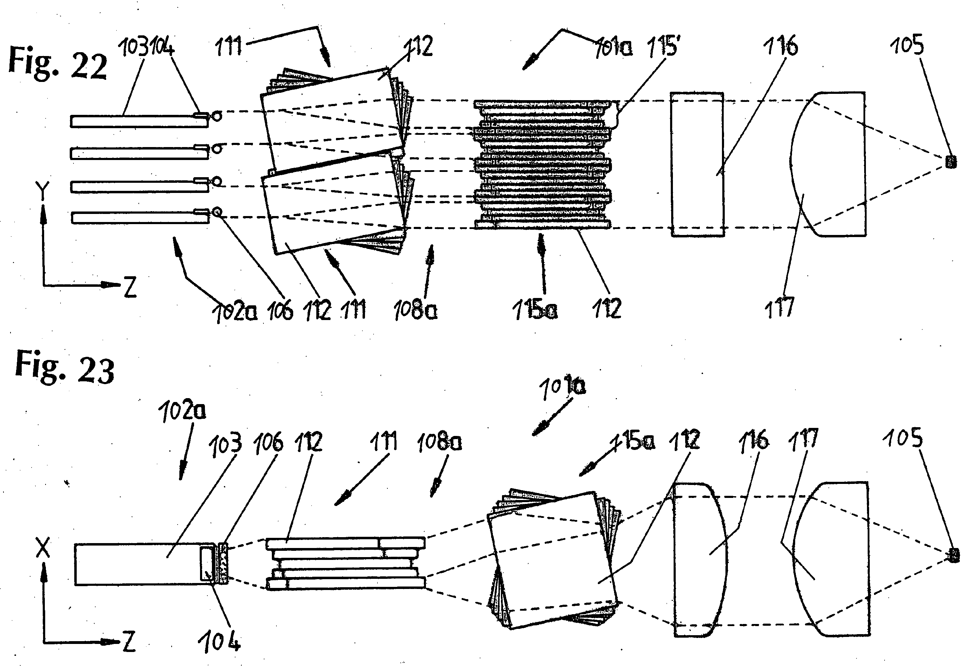

Die Figuren 22 und 23 zeigen als weitere mögliche Ausführungsform einen Diodenlaser 101a, der sich von dem Diodenlaser 101 im wesentlichen nur dadurch unterscheidet, dass die dortige Laserdiodenanordnung 102a eine höhere Anzahl an Laserbarren 104 aufweist, und zwar insgesamt vier Laserbarren 104, wobei das erste Umformelement der Laseroptik 108a von zwei Plattenfächern 111 gebildet ist, von denen jeweils ein Plattenfächer 111 zwei Laserbarren 104 bzw. Emitterebenen (X-Z-Ebenen) zugeordnet ist. Die beiden Plattenfächer 111 sind bei der Laseroptik 108a identisch ausgebildet.

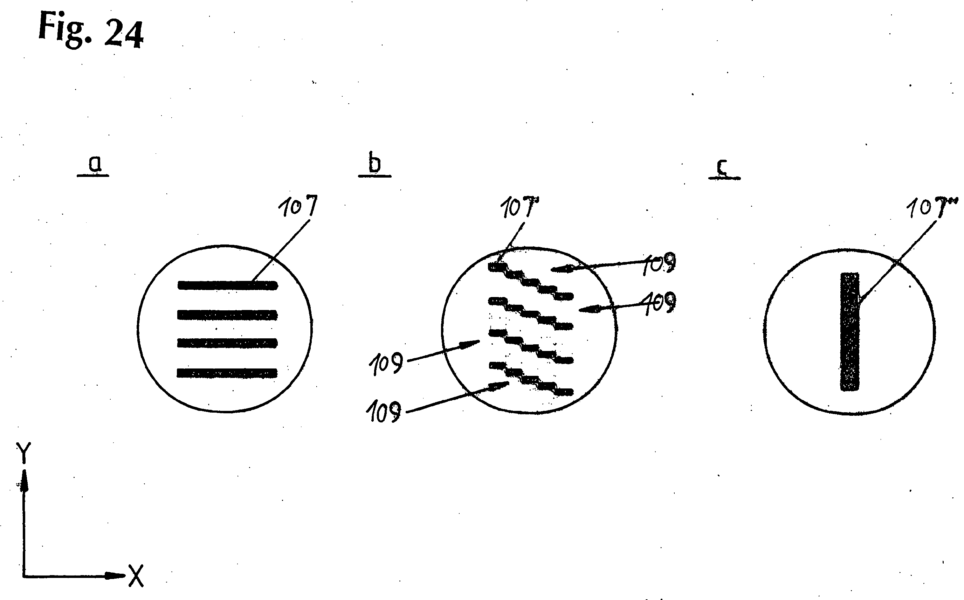

Da bei dieser Ausführung entsprechende Anzahl der Laserbarren 104 bzw. der Laserstrahlen 107 (auch Figur 24 Position a) durch die beiden Plattenfächer 111 insgesamt vier Gruppen 109 von aufgefächerten Teilstrahlen 107' gebildet werden (Figur 24 Position b), weist auch das zweite Umformelement, d.h. der dieses zweite Umformelement bildende Plattenfächer 115a insgesamt vier Einzelplattenfächer 115' auf. Die Anzahl der Platten 112 in dem Plattenfächer 115a ist wiederum gleich der Anzahl der Laserbarren 104 bzw. Emitterebenen multipliziert mit der Anzahl der Teilstrahlen 107' je Teilstrahlgruppe 109, d.h. multipliziert mit der Anzahl der Platten 112 eines der beiden Plattenfächer 111.

Vorstehend wurde u.a. auch der einfacheren Darstellung wegen davon ausgegangen, dass in jeder Ebene der Laserdiodenanordnung 102 bzw. 102a ein Laserbarren 104 vorgesehen ist. Grundsätzlich besteht die Möglichkeit, in jeder Ebene mehrere derartige Barren in der X-Achse aufeinander folgend vorzusehen und/oder zwei oder mehr als drei derartige Ebenen zu verwenden.

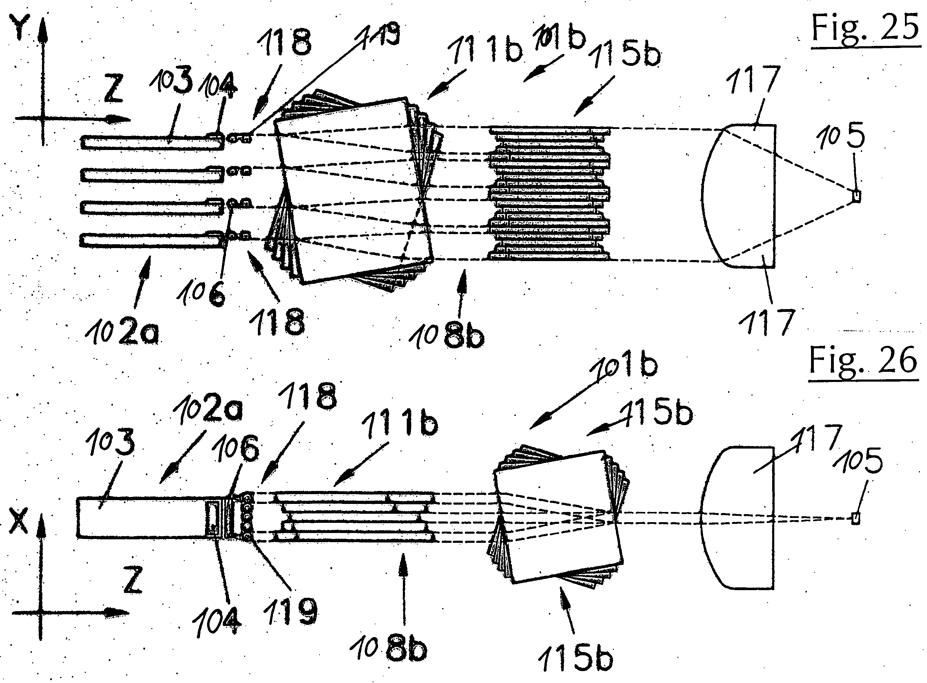

Die Figuren 25 und 26 zeigen als weitere mögliche Ausführungsform einen Diodenlaser 101b, der sich von dem Diodenlaser 101 im wesentlichen nur dadurch unterscheidet, daß die Slow-Axis-Kollimation nicht durch die Zylinderlinse 116 erfolgt, die im Strahlengang nach dem zweiten Plattenfächer 115b erfolgt, sondern durch ein Mikrolinsen-Arrey 118, welches im Strahlengang unmittelbar vor dem ersten Plattenfächer 111b angeordnet ist.

Die in den Figuren 25 und 26 allgemein mit 108b bezeichnete Laseroptik weist somit folgende Elemente auf, die - ausgehend von der der Laserdiodenanordnung 102a entsprechenden Laserdiodenanordnung 102b - in der nachstehenden Reihenfolge aneinander anschließen:
- Fast-Axis-Kollimatoren 106, und zwar jeweils einer für jede Emitterebene bzw. für jeden Laserbarren 104;
- Micorlinsen-Arrey 118 zur Slow-Axis-Kollimation;
- Plattenfächer 111b, der hinsichtlich Ausbildung und Anordnung dem Plattenfächer 111 entspricht;
- Plattenfächer 115b, der den Plattenfächer 115 entspricht sowie
- Fokussierelement oder Sammellinse 117.

Das Microlinsenarrey 118 besteht bei der dargestellten Ausführungsform aus einer Vielzahl von als Zylinderlinsen wirkenden optischen Elementen oder Zylinderlinsen 119, die mit ihrer Achse in der Y-Achse, d.h. senkrecht zur aktiven Schicht der Emitter der Laserbarren 104 orientiert sind. Die Zylinderlinsen 119 sind so angeordnet, daß jeweils mehrere Zylinderlinsen 119 in Richtung der X-Achse in einer Reihe aneinander anschließen und hierbei vorzugsweise zu einem Linsenelement zusammengefaßt sind. Jedem Laserbarren 104 oder jeder Emitterebene ist eine solche Reihe zugeordnet. Bei der dargestellen Ausführungsform ist die Anzahl der Zylinderlinsen 119 in jeder, sich in Richtung der X-Achse erstreckenden Reihe gleich der Anzahl der Platten des Plattenfächers 111b.

Die Anzahl der Platten des Plattenfächers 115b ist wiederum gleich dem Produkt aus Anzahl der Platten des Plattenfächers 111b und der Anzahl der Ebenen der Laserbarren 104 bzw. der Emitterebenen der Laserdiodenanordnung 102a. Bei der dargestellten Ausführungsform beträgt also die Anzahl der Platten des Plattenfächers 115b bei insgesamt vier Emitterebenen und fünf Platten des Plattenfächers 111b zwanzig.

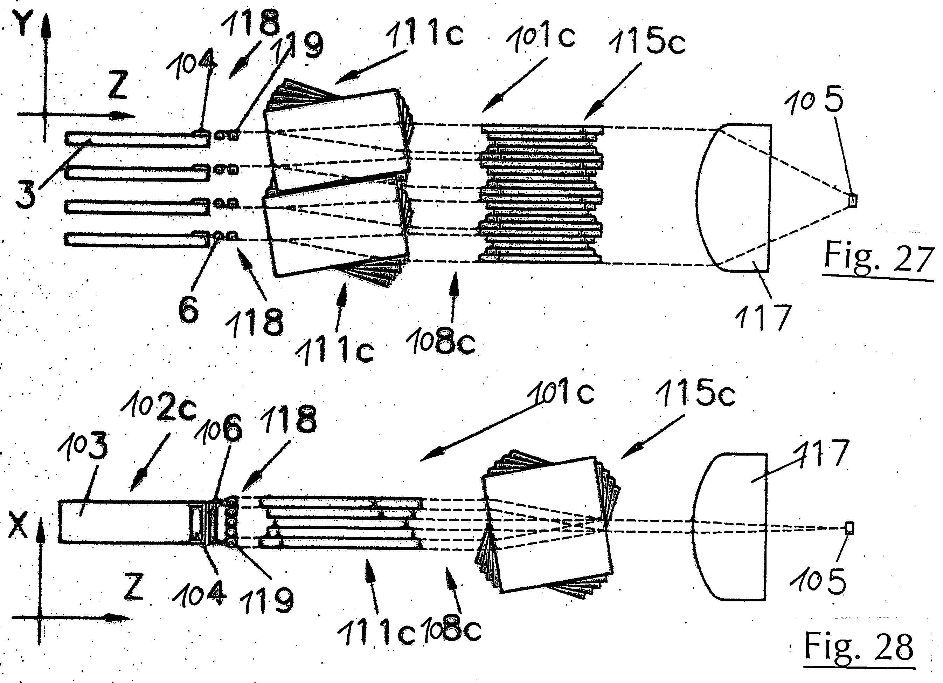

Die Figuren 27 und 28 zeigen als weitere mögliche Ausführungsform einen Diodenlaser 101c, der wiederum die der Laserdiodenanordnung 102a entsprechende Laserdiodenanordnung 102c mit vier in unterschiedlichen Ebenen angeordneten Laserbarren 104 aufweist sowie die Laseroptik 108c, die im Strahlengang auf die Laserdiodenanordnung 102c folgend die Fast-Axis-Kollimatoren 106, das MicrolinsenArrey 18 mit den Reihen der Zylinderlinsen 119, die beiden den Plattenfächer 111a entsprechenden Plattenfächer 111c sowie den dem Plattenfächer 115a entsprechenden Plattenfächer 115c aufweist, d.h. die Laseroptik 108c entspricht der Laseroptik 108a, allerdings mit dem Unterschied, daß anstelle der als Slow-Axis-Kollimator dienenden Zylinderlinse 116 die Slow-Axis-Kollimation wiederum vor dem ersten Plattenfächern 111c durch das Linsenarrey 118 erfolgt.

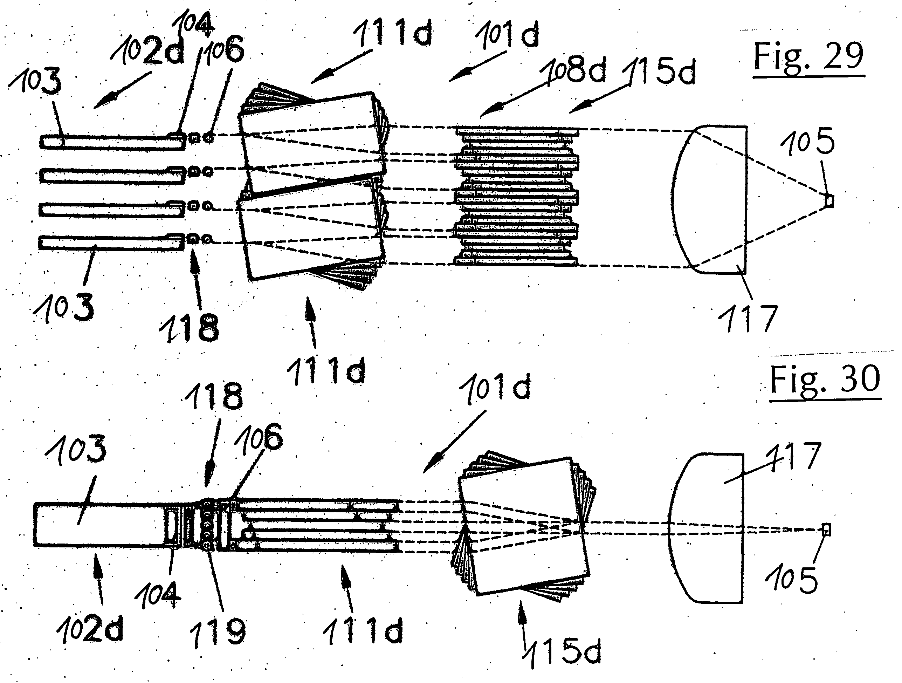

Die Figuren 29 und 30 zeigen einen Diodenlaser 101d, der sich von dem Diodenlaser 101c im wesentlichen nur dadurch unterscheidet, daß das Linsenarrey 118 zur Slow-Axis-Kollimation im Strahlengang vor dem Fast-Axis-Kollimatoren 106 angeordnet ist. Die Plattenfächer 111d bzw. 115d entsprechen wiederum den Plattenfächern 111c bzw. 115c.

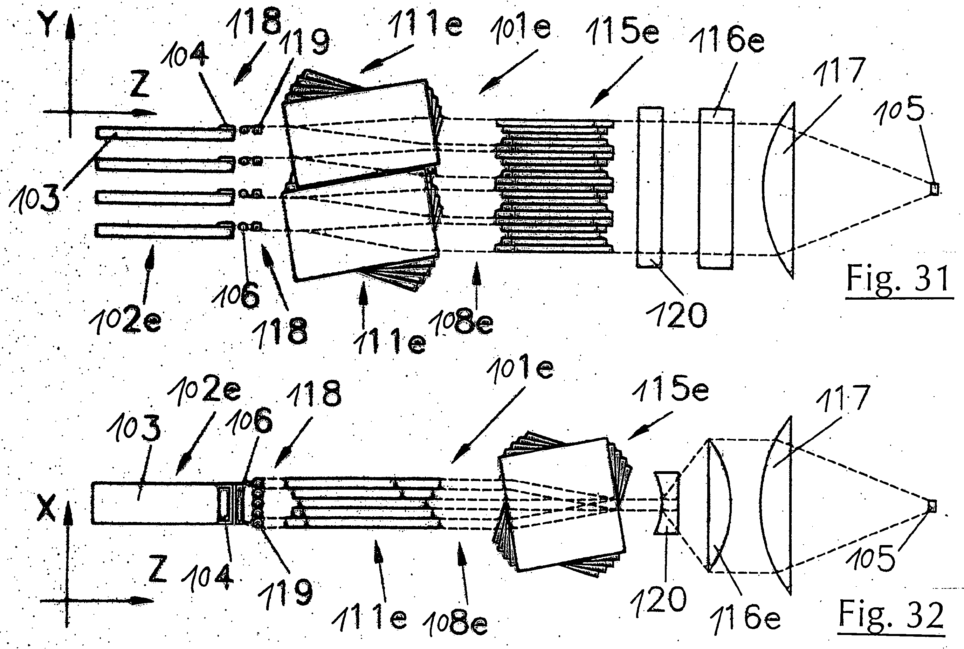

Die Figuren 31 und 32 zeigen als weitere mögliche Ausführungsform einen Diodenlaser 101e, der sich von dem Diodenlaser 101c der Figuren 27 und 28 im wesentlichen dadurch unterscheidet, daß im Strahlengang nach dem Plattenfächer 115e eine Linse 120 vorgesehen ist, die in der Slow-Axis, d.h. bei der Darstellung der Figuren 31 und 32 in der X-Achse eine Aufweitung des Strahles bewirkt. Auf die Linse 120, die als konkave Zylinderlinse ausgeführt ist und mit ihrer Krümmungsachse in der Y-Achse liegt, folgt eine der Zylinderlinse 16 entsprechende Zylinderlinse 116e, die als konvex gewölbte Linse ausgebildet ist. Die Zylinderlinse 116e wirkt als Slow-Axis-Kollimator, und zwar in der Weise, daß der aufgeweitete in der Slow-Axis (X-Achse) divergierende Strahl in einen parallelen Strahl umgeformt wird, mit einer Strahlbreite, die gleich oder etwa gleich der Breite des Strahles in der Fast-Axis (Y-Achse) ist, so daß dann mit der Sammellinse 117 ein verbesserter Fokus 105 erreicht wird. Die in den Figuren 31 und 32 mit 111e und 115e bezeichneten Plattenfächer entsprechen den Plattenfächern 111c und 115c und sind in der gleichen Weise ausgeführt, wie dies für die Plattenfächer 111c und 115c beschrieben wurde.

Der Diodenlaser 101e umfasst weiterhin die der Diodenlaseranordnung 102 entsprechende Diodenlaseranordnung 102e. Die beiden Plattenfächer 111e und 115e sind Bestandteile der Laseroptik 108e und zwar zusammen mit den Fast-Axis-Kollimatoren und den Slow-Axis-Kollimatoren sowie den Linsen 116e, 117 und 120.

Zum Diodenlaser 101e sind unterschiedlichste Varianten denkbar. So ist es beispielsweise möglich, auf die Linse 120 zur Aufweitung des Laserstrahls zu verzichten und mit der Linse 116e eine zusätzliche Slow-Axis-Kollimation vorzunehmen. Weiterhin ist es auch möglich, die Slow-Axis-Kollimatoren (Mikrolinsen-Arrey 118) und Fast-Axis-Kollimatoren 106 im Strahlengang vor dem ersten Umformelement, d.h. vor den Plattenfächern 111e im Strahlengang zu vertauschen, und zwar in der Weise, daß entsprechend den Figuren 29 und 30 im Strahlengang auf die Slow-Axis-Kollimatoren die Fast-Axis-Kollimatoren folgen.

Die Erfindung wurde voranstehend an Ausführungsbeispielen beschrieben. Es versteht sich, dass zahlreiche Änderungen sowie Abwandlungen möglich sind, ohne dass dadurch der der Erfindung zugrundeliegende Erfindungsgedanke verlassen wird.

So ist es beispielsweise auch möglich, dass die Platten 12 der Plattenfächer 8 und 9 jeweils um eine gemeinsame Fächerachse A gegeneinander verdreht sind, die in der Ebene der Plattenschmalseite 13 liegt. Auch hier sind andere Ausführungen denkbar, beispielsweise können die Platten der Plattenfächer auch um mehrere Achsen gegeneinander fächerartig verdreht sein, und zwar jeweils zwei Platten um eine Achse. Weiterhin kann die Lage der Achse bzw. Achsen auch anders gewählt sein als vorstehend beschrieben.

Vorstehend wurde davon ausgegangen, dass jedem Emitter 4.1 eine Platte 12 bzw. 112 zugeordnet ist. Grundsätzlich besteht auch die Möglichkeit, jede Platte 12 zumindest des Plattenfächers 8 oder jede Platte 112 zumindest des Plattenfächers 111 einer Gruppe von Emittern 4.1 des jeweiligen Laserbarrens, beispielsweise einer Gruppe von zwei bis fünf Emittern 4.1 zuzuordnen.

Vorstehend wurde weiterhin davon ausgegangen, dass der Fast-Axis-Kollimator 6 ein für sämtliche Emitter 4.1 gemeinsames optisches Element ist. Grundsätzlich besteht die Möglichkeit, für jeden Emitter 4.1 oder für jeweils eine Gruppe von wenigen Emittern, beispielsweise von zwei oder drei Emittern 4.1, einen eigenständigen Fast-Axis-Kollimator vorzusehen, der dann bevorzugt individuell justierbar angeordnet ist, d.h. beispielsweise in wenigstens einer Achse (z.B. X-Achse, Y-Achse und/oder Z-Achse) verstellbar und um wenigstens eine Achse (z.B. X-Achse, Y-Achse und/oder Z-Achse) schwenkbar ist.

Weiterhin besteht die Möglichkeit, dass die Platten 12 wenigstens eines Plattenfächers 8 bzw. 9 jeweils von wenigstens zwei aufeinander liegenden Einzelplatten ohne Verschränkungswinkel gebildet sind, die dann optisch die Funktion einer einzigen Platte haben.

### Bezugszeichenliste

1, 1a, 1c Diodenlaser
2, 2a Laserdiodenanordnung
3 Substrat
4 Laserbarren
5 bandförmiger Laserstrahl
5' Einzelstrahl
6 Fast-Axis-Kollimator
7 optische Anordnung
8, 9 Plattenfächer
10, 11 Plattenfächerseite
12 Platte
13, 14 Plattenseite
15 Spalt
16 Punkt
17 Slow-Axis-Kollimator
18 Sammellinse
19 Fokussieroptik
22 Treppenspiegel
23 Spiegelfläche
101, 101a - 101e Diodenlaser
102, 102a - 102e Laserdiodenanordnung
103 Substrat
104 Laserbarren
105 Fokus
106 Fast-Axis-Kollimator
107 Laserstrahl
107' Teilstrahl
107" Umgeformter Strahl
108, 108a - 108d Laseroptik
109 Teilstrahlgruppe
110 Fokussieranordnung
111, 111a - 111e Plattenfächer
112 Platte
113, 114 Schmalseite
115, 115a - 115e Plattenfächer
115' Einzelplattenfächer
116, 116e Zylinderlinse
117 Sammellinse
X-Achse
Y-Achse
Z-Achse
X-Z-Ebene, Y-Z-Ebene
X-Y-Ebene
x, x' Abmessung
y Abstand
y', y" Höhe

## Patentansprüche

1. Diodenlaser mit einer Laserdiodenanordnung (2, 2a, 102, 102a) und mit einer Laseroptik zum Umformen wenigstens eines Laserstrahlbündels bestehend aus mehreren, jeweils von Emittern (4.1) erzeugten Laserstrahlen (5, 107), wobei die Laserdiodenanordnung (2, 2a, 102, 102a) wenigstens einen, sich in einer Slow-Axis (X-Achse) erstreckenden Laserbarren (4) mit in dieser Slow-Axis (X-Achse) gegeneinander versetzten und voneinander beabstandeten Emittern (4.1) aufweist, mit wenigstens einem im Strahlengang des Laserstrahlbündels angeordneten Plattenfächer (8, 111, 111a - 111e), mit wenigstens einem im Strahlengang zwischen den Emittern (4.1) und dem Plattenfächer (8, 111, 111a - 111e) vorgesehenen Fast-Axis-Kollimator (6, 106), der zur Kollimation der Laserstrahlen (5, 107) in einer senkrecht zur Slow-Axis (X-Achse) orientierten Fast-Axis (Y-Achse) zur Formung eines im wesentlichen schmalbandigen Strahlenbündels aus den Laserstrahlen (5, 107) ausgebildet ist, bei dem der im Strahlengang auf den wenigstens einen Fast-Axis-Kollimator (6, 106) unmittelbar folgende Plattenfächer (8, 111, 111a - 111e) zur weiteren Formung des im wesentlichen schmalbandigen Strahlenbündels vorgesehen ist, der aus mehreren, um eine gemeinsame Fächerachse (A) gegen einander gedrehte Platten (12, 112) aus einem Licht leitenden Material besteht, die in Richtung senkrecht zu ihren Oberflächenseiten (12') versetzt und mit ihren Oberflächenseiten (12') in Ebenen angeordnet sind, die jeweils eine Strahlenrichtung (Z-Achse) der Laserstrahlen sowie die Fast-Axis (Y-Achse) der Laserstrahlen einschließen, wobei die Platten (12, 112) jeweils eine erste, plane Plattenschmalseite (13, 113) für einen Strahleintritt und dieser gegenüberliegend eine zweite, plane Plattenschmalseite (14, 14') für einen Strahlaustritt bilden, bei dem die Platten (12, 112) des Plattenfächers (8, 111, 111a - 111e) so angeordnet sind, dass den Emittern (4.1) ein und desselben Laserbarrens (4) oder einer Emittergruppe von maximal fünf Emittern (4.1) ein und desselben Laserbarrens (4) jeweils eine eigenständige Platte (12, 112) zugeordnet ist, wobei der im Fast-Axis-Kollimator (6, 106) kollimierte Laserstrahl (5) jedes Emitters (4.1) im Bereich der Fächerachse (A) auf die diesem Emitter (4.1) zugewandte erste plane Plattenschmalseite (13, 113) auftrifft, bei dem die Plattendicke der Platten (12, 112) so gewählt ist, dass die Laserstrahlen (5, 107) jedes Emitters (4.1) oder jeder Emittergruppe die diesem Emitter (4.1) oder dieser Emittergruppe zugehörige Platte (12, 112) ohne Reflektion an den Plattenoberflächenseiten (12') durchstrahlen, und
bei dem hierfür die Platten (12, 112) des Plattenfächers (8, 111, 111a - 111e) eine Plattendicke aufweisen, die zumindest gleich, bevorzugt aber größer ist als eine Divergenz, die der wenigstens eine von dem jeweiligen Emitter (4.1) bzw. von der jeweiligen Emittergruppe ausgesendete und die zugehörige Platte (12, 112) durchstrahlende Laserstrahl (5, 107) an der zweiten Plattenschmalseite (14, 114) in der Slow-Axis (X-Achse) aufweist.

2. Diodenlaser nach Anspruch 1, **dadurch gekennzeichnet, dass** die jeweilige Emittergruppe aus wenigstens zwei oder drei Emittern (4.1) besteht.

3. Diodenlaser nach Anspruch 1 oder 2, **dadurch gekennzeichnet, dass** jede Platte (12, 112) nur einem Emitter (4.1) oder nur einem Laserstrahl (5, 107) zugeordnet ist.

4. Diodenlaser nach einem der vorhergehenden Ansprüche, **dadurch gekennzeichnet, dass** der Emitterabstand, den zwei einander benachbarte Emitter (4.1) oder zwei einander benachbarte Emittergruppen in Richtung der Slow-Axis voneinander aufweisen, gleich der Dicke der Platten (12, 112) oder einem Vielfachen der Dicke der Platten (12, 112) ist.

5. Diodenlaser nach einem der vorhergehenden Ansprüche, **dadurch gekennzeichnet, dass** der Fast-Axis-Kollimator (6, 106) für sämtliche Emitter (4.1) gemeinsam vorgesehen ist oder mehrere Fast-Axis-Einzelkollimatoren (6, 106), vorzugsweise individuell einstellbare Fast-Axis- Einzelkollimatoren vorgesehen sind, und zwar jeweils ein Fast-Axis Einzelkollimatoren (6, 106) für jeden Emitter (4.1) oder eine Emittergruppe.

6. Diodenlaser nach einem der vorhergehenden Ansprüche, **dadurch gekennzeichnet, dass** der Plattenfächer (8, 111, 111a - 111e) ein Auffächern des wenigstens einen Laserstrahlbündels in mehrere Teilstrahlen (5.1) bewirkt, die in der Fast-Axis sowie auch in der Slow-Axis gegeneinander versetzt sind.

7. Diodenlaser nach einem der vorhergehenden Ansprüche, **dadurch gekennzeichnet, dass** im Strahlengang auf den Plattenfächer (8, 111, 111a - 111e) folgend wenigstens ein weiteres Umformelement zum Zusammenführen der durch den Plattenfächer (8, 111, 111a - 111e) aufgefächerten Teilstrahlen (5.1, 7.1) vorgesehen ist, wobei beispielsweise das weitere Umformelement ein weiterer Plattenfächer (9, 115, 115 - 115e) ist, dessen Platten (12, 112) mit ihren Oberflächenseiten (12') senkrecht zur Fast-Axis der Laserstrahlen (5, 5', 107, 107') orientiert sind.

8. Diodenlaser nach einem der vorhergehenden Ansprüche, **dadurch gekennzeichnet, dass** die Plattenschmalseiten (13, 14, 113, 114) des wenigstens einen Plattenfächers (8, 9, 111, 115, 115 - 115e) fächerartig derart gegeneinander verdreht sind, dass die erste Plattenschmalseite (13, 113) jeder Platte (12, 112) in einer Ebene (E) liegt, die mit der Ebene der ersten Plattenschmalseite (13, 113) jeder benachbarten Platte (12, 112) einen Winkel (α) einschließt, dass die ersten Plattenschmalseiten (13, 113) in ihrer Gesamtheit eine erste Plattenfächerseite (13, 113) und die zweiten Plattenschmalseiten (14, 114) in ihrer Gesamtheit eine zweite Plattenfächerseite (11) jeweils für den Eintritt oder Austritt des den Plattenfächer durchstrahlenden wenigstens einen Laserstrahls bilden, und dass die Ebenen (E) der Plattenschmalseiten (13, 14, 113, 114) sowie die Fächerachse (A) senkrecht zu den Oberflächenseiten (12') der Platten (12, 112) orientiert sind.

9. Diodenlaser nach einem der vorhergehenden Ansprüche, **dadurch gekennzeichnet, dass** die Plattenschmalseiten (13, 14, 113, 114) an jeder Platte (12, 112) parallel oder im Wesentlichen parallel zueinander angeordnet sind, und/oder dass die Platten des Plattenfächers (8, 111, 111a - 111e) jeweils von wenigstens zwei aufeinander liegenden Einzelplatten gebildet sind, und/oder dass wenigstens ein Slow-Axis-Kollimator (116) im Strahlengang nach dem zweiten Umformelement (115, 115 - 115e) vorgesehen ist.

10. Diodenlaser nach einem der vorhergehenden Ansprüche, **dadurch gekennzeichnet, dass** in wenigstens zwei Emitterebenen (X-Z-Ebene), die parallel zueinander angeordnet und in einer Achse (Y-Achse) senkrecht zu den Emitterebenen (X-Z-Ebene) um einen Abstand (y) voneinander beabstandet sind, jeweils wenigstens eine Emittergruppe (104) vorgesehen ist dass die Laserstrahlen (107) jeder Emittergruppe (104) durch ein erstes Umformelement (111, 111a - 111e) in eine eigene Teilstrahlgruppe (109) von aufgefächerten Teilstrahlen (107') umgeformt wird, dass die Teilstrahlgruppen (109) in der zweiten Achse (Y-Achse) gegeneinander versetzt sind, und dass durch das zweite Umformelement (115, 115 - 115e)die Teilstrahlen (107') sämtlicher Teilstrahlgruppen (109) zu dem aus den zweiten Umformelement austretenden umgeformten Laserstrahl (107") umgeformt werden, wobei beispielsweise die durch das erste Umformelement (111, 111a - 111e) gebildeten Teilstrahlgruppen (109) derart in der zweiten Achse (Y-Achse) versetzt sind und der Abstand (y') zwischen jeweils gleichartigen Teilstrahlen (107') benachbarter Gruppen (109) dem Abstand (y) der Emitterebenen (X-Z-Ebene) der Laserdiodenanordnung (102, 102a) entspricht, und/oder wobei beispielsweise die Emittergruppen jeweils von einem mehrere Emitter aufweisenden Laserbarren (104) gebildet ist.

11. Diodenlaser nach einem der vorhergehenden Ansprüche, **dadurch gekennzeichnet, dass** in jeder Emitterebene (X-Z-Ebene) eine Emittergruppe (104) vorgesehen ist.

12. Diodenlaser nach einem der vorhergehenden Ansprüche, **dadurch gekennzeichnet, dass** das erste Umformelement von wenigstens einem ersten Plattenfächer (111, 111a - 111e) gebildet ist, wobei beispielsweise der erste Plattenfächer (111, 111a - 111e) für sämtliche Emitterebenen gemeinsam vorgesehen ist und/oder das zweite Umformelement von wenigstens einem zweiten Plattenfächer (115, 115 - 115e) gebildet ist und/oder der zweite Plattenfächer (115, 115 - 115e) für sämtliche Teilstrahlgruppen (109) der durch das erste Umformelement (111, 111a - 111e) umgeformten Laserstrahlen (107) gemeinsam vorgesehen ist und/oder der zweite Plattenfächer (115, 115 - 115e) aus mehreren aneinander anschließenden Einzelplattenfächern(115') besteht und beispielsweise für jede Teilstrahlgruppe (109) einen Einzelplattenfächer (115') aufweist.

13. Diodenlaser nach einem der vorhergehenden Ansprüche, **dadurch gekennzeichnet, dass** der zweite Plattenfächer (115, 115 - 115e) eine Vielzahl von Platten (112) aus einem lichtdurchlässigen Material aufweist, und dass die Anzahl dieser Platten (112) gleich der Anzahl der durch das erste Umformelement gebildeten Teilstrahlen (107') ist.

14. Diodenlaser nach einem der vorhergehenden Ansprüche, **dadurch gekennzeichnet, dass** der zweite Plattenfächer (115, 115 - 115e) eine Vielzahl von Platten (112) aus einem lichtdurchlässigen Material aufweist, und dass die Anzahl dieser Platten (112) gleich der Anzahl der Emitterebenen (X-Z-Ebene) multipliziert mit der Anzahl der Platten (112) ist, die der wenigstens eine erste Plattenfächer (111, 111a - 111e) jeweils aufweist.

## Claims

1. Diode laser having a laser diode arrangement (2, 2a, 102, 102a) and having a laser optic for reshaping at least one laser beam bundle consisting of a plurality of laser beams (5, 107) respectively generated by emitters (4.1), wherein the laser diode arrangement (2, 2a, 102, 102a) has at least one laser bar (4) extending in a slow axis (X axis) with emitters (4.1) offset with respect to one another and spaced apart from one another in said slow axis (X axis), having at least one plate fan (8, 111, 111a - 111e) arranged in the beam path of the laser beam bundle, having at least one fast-axis collimator (6, 106) provided in the beam path between the emitters (4.1) and the plate fan (8, 111, 111a - 111e), the fast-axis collimator (6, 106) being configured to collimate the laser beams (5, 107) in a fast axis (Y axis) oriented so as to be perpendicular to the slow axis (X axis) in order to shape an essentially narrow-band beam bundle from the laser beams (5, 107), wherein the plate fan (8, 111, 111a - 111e) immediately following the at least one fast-axis collimator (6, 106) is provided to shape the essentially narrow-band beam bundle further, the plate fan (8, 111, 111a - 111e) consisting of a plurality of plates (12, 112) made of a light-conducting material and turned with respect to one another about a common fan axis (A), which are offset in a direction perpendicular to their surface sides (12') and arranged with their surface sides (12') in planes, which respectively include a beam direction (Z axis) of the laser beams as well as the fast axis (Y axis) of the laser beams, wherein the plates (12, 112) respectively form a first flat plate-edge side (13, 113) for a beam entrance and, opposite thereto, a second flat plate-edge side (14, 14') for a beam exit, wherein the plates (12, 112) of the plate fan (8, 111, 111a - 111 e) are arranged such that a separate plate (12, 112) is respectively associated with the emitters (4.1) of one and the same laser bar (4) or an emitter group of at most five emitters (4.1) of one and the same laser bar (4), wherein the laser beam (5) of each emitter (4.1) collimated in the fast-axis collimator (6, 106) impinges the first flat plate-edge side (13, 113) facing this emitter (4.1) in the area of the fan axis (A), wherein the plate thickness of the plates (12, 112) is chosen so that the laser beams (5, 107) of each emitter (4.1) or of each emitter group pass through the plate (12, 112) associated with this emitter (4.1) or this emitter group without any reflection on the plate surface sides (12, 112), and wherein, for this purpose, the plates (12, 112) of the plate fan (8, 111, 111a - 111e) have a plate thickness that is at least the same as, but preferably greater than, a divergence that the laser beam (5, 107) emitted by the at least one of the respective emitters (4.1) or by the respective emitter group and passing through the corresponding plate (12, 112) comprises at the second plate-edge side (14, 114) in the slow axis (X axis).

2. The diode laser according to claim 1, **characterized in that** the respective emitter group consists of at least two or three emitters (4.1).

3. The diode laser according to claim 1 or 2, **characterized in that** each plate (12, 112) is associated with only one emitter (4.1) or only one laser beam (5, 107).

4. The diode laser according to one of the preceding claims, **characterized in that** the emitter spacing between two adjacent emitters (4.1) or two adjacent emitter groups in the direction of the slow axis is equal to the thickness of the plates (12, 112) or a multiple of the thickness of the plates (12, 112).

5. The diode laser according to one of the preceding claims, **characterized in that** the fast-axis collimator (6, 106) is provided for all emitters (4.1) collectively or a plurality of individual fast-axis collimators (6, 106), preferably individually adjustable individual fast-axis collimators, are provided, namely respectively one individual fast-axis collimator (6, 106) for each emitter (4.1) or an emitter group.

6. The diode laser according to one of the preceding claims, **characterized in that** the plate fan (8, 111, 111a - 111e) causes a fanning-out of the at least one laser beam bundle into a plurality of partial beams (5.1) which are offset with respect to one another in the fast axis as well as in the slow axis.

7. The diode laser according to one of the preceding claims, **characterized in that**, following the plate fan (8, 111, 111a - 111 e) in the beam path, at least one further re-shaping element is provided for combining the partial beams (5.1, 7.1) fanned out by the plate fan (8, 111, 111a - 111e), wherein the further re-shaping element is, for example, a further plate fan (9, 115, 115 - 115e), the plates (12, 112) of which are oriented with their surface sides (12') perpendicular to the fast axis of the laser beams (5, 5', 107, 107').

8. The diode laser according to one of the preceding claims, **characterized in that** the plate-edge sides (13, 14, 113, 114) of the at least one plate fan (8, 9, 111, 115, 115 - 115e) are turned with respect to one another in the manner of a fan such that the first plate-edge side (13, 113) of each plate (12, 112) lies in a plane (E) that includes an angle (α) with the plane of the first plate-edge side (13, 113) of each adjacent plate (12, 112), **in that** the first plate-edge sides (13, 113) together form a first plate-fan side (13, 113) and the second plate-edge sides (14, 114) together form a second plate-fan side (11) respectively for the entrance or exit of the at least one laser beam passing through the plate fan, and **in that** the planes (E) of the plate-edge sides (13, 14, 113, 114) as well as the fan axis (A) are oriented so as to be perpendicular to the surface sides (12') of the plates (12, 112).

9. The diode laser according to one of the preceding claims, **characterized in that** the plate-edge sides (13, 14, 113, 114) on each plate (12, 112) are arranged so as to be parallel or essentially parallel to one another, and/or **in that** the plates of the plate fan (8, 111, 111a - 111e) are respectively formed by at least two individual plates lying on top of one another, and/or **in that** at least one slow-axis collimator (116) is provided after the second re-shaping element (115, 115 - 115e) in the beam path.

10. The diode laser according to one of the preceding claims, **characterized in that** at least one emitter group (104) is respectively provided in at least two emitter planes (X-Z planes), which are arranged so as to be parallel to one another and are spaced apart from one another in an axis (Y axis) parallel to the emitter planes (X-Z planes) by a distance (y), **in that** the laser beams (107) of each emitter group (104) are re-shaped by a first re-shaping element (111, 111a - 111e) into a separate partial beam group (109) of fanned-out partial beams (107'), **in that** the partial beam groups (109) are offset with respect to one another in the second axis (Y axis), and **in that** the partial beams (107') of all partial beam groups (109) are re-shaped by the second re-shaping element (115, 115 - 115e) into the re-shaped laser beam (107") exiting the second re-shaping element, wherein, for example, the partial beam groups (109) formed by the first re-shaping element (111, 111a - 111e) are offset in the second axis (Y axis) and the distance (y') between respectively similar partial beams (107') of adjacent groups (109) corresponds to the distance (y) between the emitter planes (X-Z planes) of the laser diode arrangement (102, 102a), and/or wherein, for example, the emitter groups are respectively formed by a laser bar (104) comprising a plurality of emitters.

11. The diode laser according to one of the preceding claims, **characterized in that** an emitter group (104) is provided in each emitter plane (X-Z planes).

12. The diode laser according to one of the preceding claims, **characterized in that** the first re-shaping element is formed by at least one first plate fan (111, 111a - 111e), wherein, for example, the first plate fan (111, 111a - 111e) is provided for all emitter planes collectively and/or the second re-shaping element is formed by at least one second plate fan (115, 115 - 115e) and/or the second plate fan (115, 115 - 115e) is provided for all partial beam groups (109) of the laser beams (107) re-shaped by the first re-shaping element (111, 111a - 111e) collectively and/or the second plate fan (115, 115 - 115e) consists of a plurality of individual plate fans (115') connected to one another and, for example, has an individual plate fan (115') for each partial beam group (109).

13. The diode laser according to one of the preceding claims, **characterized in that** the second plate fan (115, 115 - 115e) comprises a plurality of plates (112) made of a light-permeable material and **in that** the number of these plates (112) is equal to the number of partial beams (107') formed by the first re-shaping element.

14. The diode laser according to one of the preceding claims, **characterized in that** the second plate fan (115, 115 - 115e) has a plurality of plates (112) made of a light-permeable material and **in that** the number of these plates (112) is equal to the number of emitter planes (X-Z planes) multiplied by the number of plates (112) respectively comprised by the at least one first plate fan (111, 111a - 111e).

## Revendications

1. Laser à diode comportant un agencement de diodes laser (2, 2a, 102, 102a) et comportant une optique laser pour former au moins un faisceau de rayons laser constitué de plusieurs rayons laser (5, 107) générés respectivement par des émetteurs (4.1), l'agencement de diodes laser (2, 2a, 102, 102a) présentant au moins une barre laser (4) qui s'étend sur un axe lent (axe X) et présente des émetteurs (4.1) décalés les uns par rapport aux autres sur cet axe lent (axe X) et espacés les uns des autres, comportant au moins un éventail de plaques (8, 111, 111a - 111e) disposé dans le trajet optique du faisceau de rayons laser, comportant au moins un collimateur d'axe rapide (6, 106) prévu dans le trajet optique entre les émetteurs (4.1) et l'éventail de plaques (8, 111, 111a - 111e), qui est conçu pour collimater les rayons laser (5, 107) sur un axe rapide (axe Y) orienté perpendiculairement à l'axe lent (axe X) afin de former un faisceau de rayons à bande sensiblement étroite à partir des rayons laser (5, 107), dans lequel l'éventail de plaques (8, 111, 111a - 111e), qui suit directement ledit au moins un collimateur d'axe rapide (6, 106) dans le trajet optique est prévu pour une mise en forme supplémentaire du faisceau de rayons à bande sensiblement étroite, est composé de plusieurs plaques (12, 112) constituées d'un matériau conducteur de la lumière, qui sont tournées les unes par rapport aux autres autour d'un axe d'éventail commun (A), qui sont décalées dans la direction perpendiculaire à leurs côtés de surface (12') et disposées avec leurs côtés de surface (12') dans des plans qui contiennent chacun une direction de rayons (axe Z) des rayons laser ainsi que l'axe rapide (axe Y) des rayons laser, les plaques (12, 112) formant respectivement un premier petit côté de plaque plan (13, 113) pour une entrée de rayons et, à l'opposé de celui-ci, un deuxième petit côté de plaque plan (14, 14') pour une sortie de rayons, dans lequel les plaques (12, 112) de l'éventail de plaques (8, 111, 111a - 111e) sont disposées de telle sorte que les émetteurs (4.1) d'une seule et même barre laser (4) ou d'un groupe d'émetteurs de cinq émetteurs (4.1) au maximum d'une seule et même barre laser (4) soient associés chaque fois à une plaque indépendante (12, 112), le faisceau laser (5) collimaté dans le collimateur d'axe rapide (6, 106) de chaque émetteur (4.1) atteignant le premier petit côté de plaque plan (13, 113) qui est tourné vers cet émetteur (4.1) dans la zone de l'axe d'éventail (A), dans lequel l'épaisseur de plaque des plaques (12, 112) est choisie de telle sorte que les rayons laser (5, 107) de chaque émetteur (4.1) ou de chaque groupe d'émetteurs traversent la plaque (12, 112) associée à cet émetteur (4.1) ou à ce groupe d'émetteurs sans réflexion sur les côtés de surface de plaque (12'), et dans lequel, à cet effet, les plaques (12, 112) de l'éventail de plaques (8, 111, 111a - 111e) présentent une épaisseur de plaque qui est au moins égale, mais de préférence supérieure, à une divergence que ledit au moins un rayon laser (5, 107) émis par l'émetteur (4.1) respectif ou par le groupe d'émetteurs respectif et qui traverse la plaque associée (12, 112) présente sur le deuxième petit côté de plaque (14, 114) sur l'axe lent (axe X).

2. Laser à diode selon la revendication 1, **caractérisé en ce que** le groupe d'émetteurs respectif est composé d'au moins deux ou trois émetteurs (4.1).

3. Laser à diode selon la revendication 1 ou 2, **caractérisé en ce que** chaque plaque (12, 112) est associée à un seul émetteur (4.1) ou à un seul rayon laser (5, 107).

4. Laser à diode selon l'une des revendications précédentes, **caractérisé en ce que** la distance que présentent entre eux deux émetteurs (4.1) adjacents ou deux groupes d'émetteurs adjacents dans la direction de l'axe lent est égale à l'épaisseur des plaques (12, 112) ou à un multiple de l'épaisseur des plaques (12, 112).

5. Laser à diode selon l'une des revendications précédentes, **caractérisé en ce que** le collimateur d'axe rapide (6, 106) est prévu en commun pour tous les émetteurs (4.1) ou plusieurs collimateurs d'axe rapide individuels (6, 106), de préférence des collimateurs d'axe rapide individuels réglables individuellement, sont prévus, à savoir chaque fois un collimateur d'axe rapide individuel (6, 106) pour chaque émetteur (4.1) ou un groupe d'émetteurs.

6. Laser à diode selon l'une des revendications précédentes, **caractérisé en ce que** l'éventail de plaques (8, 111, 111a - 111e) produit un étalement dudit au moins un faisceau de rayons laser en plusieurs faisceaux partiels (5.1) qui sont décalés les uns par rapport aux autres sur l'axe rapide ainsi que sur l'axe lent.

7. Laser à diode selon l'une des revendications précédentes, **caractérisé en ce qu'**à la suite de l'éventail de plaques (8, 111, 111a - 111e) dans le trajet optique, il est prévu au moins un autre élément de mise en forme pour réunir les faisceaux partiels (5.1, 7.1) étalés par l'éventail de plaques (8, 111, 111a - 111e), l'autre élément de mise en forme étant, par exemple, un autre éventail de plaques (9, 115, 115 - 115e) dont les plaques (12, 112) sont orientées avec leurs côtés de surface (12') perpendiculairement à l'axe rapide des rayons laser (5, 5', 107, 107').

8. Laser à diode selon l'une des revendications précédentes, **caractérisé en ce que** les petits côtés de plaque (13, 14, 113, 114) dudit au moins un éventail de plaques (8, 9, 111, 115, 115 - 115e) sont tournés les uns par rapport aux autres en éventail de telle sorte que le premier petit côté de plaque (13, 113) de chaque plaque (12, 112) se trouve dans un plan (E) qui forme un angle (α) avec le plan du premier petit côté de plaque (13, 113) de chaque plaque adjacente (12, 112), que les premiers petits côtés de plaque (13, 113) forment dans leur ensemble un premier côté d'éventail de plaques (13, 113) et les deuxièmes petits côtés de plaque (14, 114) forment dans leur ensemble un deuxième côté d'éventail de plaques (11), respectivement pour l'entrée ou la sortie dudit au moins un faisceau laser qui traverse l'éventail de plaques, et que les plans (E) des petits côtés de plaque (13, 14, 113, 114) ainsi que l'axe d'éventail (A) sont orientés perpendiculairement aux côtés de surface (12') des plaques (12, 112).

9. Laser à diode selon l'une des revendications précédentes, **caractérisé en ce que** les petits côtés de plaque (13, 14, 113, 114) sont disposés parallèlement ou sensiblement parallèlement l'un à l'autre sur chaque plaque (12, 112), et/ou que les plaques de l'éventail de plaques (8, 111, 111a - 111e) sont formées chacune par au moins deux plaques individuelles superposées, et/ou qu'au moins un collimateur d'axe lent (116) est prévu dans le trajet optique après le deuxième élément de mise en forme (115, 115 - 115e).

10. Laser à diode selon l'une des revendications précédentes, **caractérisé en ce que** dans au moins deux plans d'émetteurs (plan X-Z), qui sont disposés parallèlement l'un à l'autre et sont espacés l'un de l'autre d'une distance (y) sur un axe (axe Y) perpendiculaire aux plans d'émetteurs (plan X-Z), il est prévu chaque fois au moins un groupe d'émetteurs (104), que les faisceaux laser (107) de chaque groupe d'émetteurs (104) sont mis en forme par un premier élément de mise en forme (111, 111a - 111e) en un groupe de faisceaux partiels (109) séparé formé de faisceaux partiels déployés en éventail (107'), que les groupes de faisceaux partiels (109) sont décalés les uns par rapport aux autres sur le deuxième axe (axe Y) et que les faisceaux partiels (107') de tous les groupes de faisceaux partiels (109) sont mis en forme par le deuxième élément de mise en forme (115, 115 -115e) en un faisceau laser mis en forme (107") sortant du deuxième élément de mise en forme, dans lequel, par exemple, les groupes de faisceaux partiels (109) formés par le premier élément de mise en forme (111, 111a - 111e) sont décalés sur le deuxième axe (axe Y) de telle sorte que la distance (y') entre des faisceaux partiels (107') respectivement identiques de groupes (109) adjacents correspond à la distance (y) des plans d'émetteurs (plan X-Z) de l'agencement de diodes laser (102, 102a), et/ou dans lequel, par exemple, les groupes d'émetteur sont chaque fois formés par une barre laser (104) présentant plusieurs émetteurs.

11. Laser à diode selon l'une des revendications précédentes, **caractérisé en ce qu'**un groupe d'émetteurs (104) est prévu dans chaque plan d'émetteurs (plan X-Z).

12. Laser à diode selon l'une des revendications précédentes, **caractérisé en ce que** le premier élément de mise en forme est formé par au moins un premier éventail de plaques (111, 111a - 111e), dans lequel, par exemple, le premier éventail de plaques (111, 111a - 111e) est prévu en commun pour tous les plans d'émetteurs et/ou le deuxième élément de mise en forme est formé par au moins un deuxième éventail de plaques (115, 115 - 115e) et/ou le deuxième éventail de plaques (115, 115 - 115e) est prévu en commun pour tous les groupes de faisceaux partiels (109) des faisceaux laser (107) mis en forme par le premier élément de mise en forme (111, 111a - 111e) et/ou le deuxième éventail de plaques (115, 115 - 115e) est constitué de plusieurs éventails de plaques individuels (115') contigus et présente, par exemple, un éventail de plaques individuel (115') pour chaque groupe de faisceaux partiels (109).

13. Laser à diode selon l'une des revendications précédentes, **caractérisé en ce que** le deuxième éventail de plaques (115, 115 - 115e) présente une pluralité de plaques (112) en un matériau transmettant la lumière, et que le nombre de ces plaques (112) est égal au nombre de faisceaux partiels (107') formés par le premier élément de mise en forme.

14. Laser à diode selon l'une des revendications précédentes, **caractérisé en ce que** le deuxième éventail de plaques (115, 115 - 115e) présente une pluralité de plaques (112) en un matériau transmettant la lumière, et que le nombre de ces plaques (112) est égal au nombre de plans d'émetteurs (plan X-Z) multiplié par le nombre de plaques (112) que présente chaque fois ledit au moins un premier éventail de plaques (111, 111a - 111e).
